(19) Europäisches Patentamt
European Patent Office
Office européen des brevets

(11) **EP 4 475 652 A1**

(12) **EUROPEAN PATENT APPLICATION**

(43) Date of publication:
**11.12.2024 Bulletin 2024/50**

(21) Application number: **24176956.1**

(22) Date of filing: **21.05.2024**

(51) International Patent Classification (IPC):
**H10K 59/80** (2023.01)   **H10K 59/38** (2023.01)
**H10K 50/858** (2023.01)   **H10K 50/852** (2023.01)

(52) Cooperative Patent Classification (CPC):
**H10K 59/879; H10K 59/38; H10K 59/876**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **06.06.2023 JP 2023093308**

(71) Applicant: **CANON KABUSHIKI KAISHA**
**Tokyo 146-8501 (JP)**

(72) Inventors:
• **KAJIMOTO, Norifumi**
  **Tokyo (JP)**
• **ITO, Takayuki**
  **Tokyo (JP)**
• **SANO, Hiroaki**
  **Tokyo (JP)**
• **MATSUDA, Yojiro**
  **Tokyo (JP)**

(74) Representative: **WESER & Kollegen**
**Patentanwälte PartmbB**
**Radeckestraße 43**
**81245 München (DE)**

(54) **LIGHT EMITTING DEVICE, DISPLAY DEVICE, PHOTOELECTRIC CONVERSION DEVICE, ELECTRONIC APPARATUS, AND WEARABLE DEVICE**

(57)  A light emitting device (100) in which light emitting elements (103), each of which comprises a light extraction structure (104) arranged to cover a light emitting layer, are arranged, and the light emitting elements (103) include a red light emitting element (103r), a green light emitting element (103g), and a blue light emitting element (103b), and comprise a resonant structure corresponding to each light emission color. If $\lambda on\_g$ is a resonant peak wavelength in the resonant structure of the green light emitting element (103g), $\lambda g$ is a peak wavelength of the green light emitting element (103g), $\lambda on\_b$ is a resonant peak wavelength in the resonant structure of the blue light emitting element (103b), and $\lambda b$ is a peak wavelength the blue light emitting element (103b), $\Delta g = \lambda on\_g - \lambda g > 0$, $\Delta b = \lambda on\_b - \lambda b > 0$, and $\Delta g - \Delta b \geq 0$ are satisfied.

**F I G. 2A**

EP 4 475 652 A1

**Description**

BACKGROUND OF THE INVENTION

Field of the Invention

The present invention relates to a light emitting device, a display device, a photoelectric conversion device, an electronic apparatus, and a wearable device.

Description of the Related Art

Japanese Patent Laid-Open No. 2007-316611 describes the resonant wavelength configuration of an optical resonant structure in each of red, green, and blue light emitting elements, which is used to reduce a color shift at a wide viewing angle in a multicolor display device arranged with light emitting elements having the optical resonant structure.

SUMMARY OF THE INVENTION

In a light emitting device, in order to improve the light extraction efficiency to reduce power consumption or the like, a light extraction structure such as a microlens may be provided so as to cover a light emitting element having an optical resonant structure. In the light emitting element having the light extraction structure, color mixture with an adjacent light emitting element and optical conditions such as a total reflection condition change due to the light extraction structure, and a relationship between the resonant wavelength and color shift changes.

Some embodiments of the present invention provide a technique advantageous in lowering the visibility of a color shift.

The present invention in its first aspect provides a light emitting device as specified in claims 1 to 16.

The present invention in its second aspect provides a display device as specified in claim 17.

The present invention in its third aspect provides a photoelectric conversion device as specified in claim 18.

The present invention in its fourth aspect provides an electronic apparatus as specified in claim 19.

The present invention in its fifth aspect provides a wearable device as specified in claim 20.

Further features of the present invention will become apparent from the following description of exemplary embodiments (with reference to the attached drawings).

BRIEF DESCRIPTION OF THE DRAWINGS

Figs. 1A and 1B are plan views showing an example of the arrangement of a light emitting device according to an embodiment;

Figs. 2A and 2B are sectional views each showing an example of the arrangement of the light emitting device shown in Figs. 1A and 1B;

Figs. 3A to 3D are views for explaining light rays of the light emitting device shown in Figs. 1A and 1B;

Fig. 4 is a graph for explaining a color shift of the light emitting device shown in Figs. 1A and 1B;

Figs. 5A and 5B are views showing an example of the arrangement of light emission positions and microlenses of the light emitting device shown in Figs. 1A and 1B;

Figs. 6A and 6B are graphs showing the radiation angle in the light emitting layer and the relative light amount of the light emitting device shown in Figs. 1A and 1B;

Fig. 7 is a graph showing the emission spectrum of the light emitting device shown in Figs. 1A and 1B;

Fig. 8 is a table for explaining examples and comparative examples of this embodiment;

Fig. 9 is a table for explaining examples and comparative examples of this embodiment;

Fig. 10 is a table for explaining examples and comparative examples of this embodiment;

Fig. 11 is a table for explaining examples and comparative examples of this embodiment;

Fig. 12 is a table for explaining examples and comparative examples of this embodiment;

Figs. 13A and 13B are sectional views showing an example of the arrangement of the pixel of the light emitting device shown in Figs. 1A and 1B;

Figs. 14A to 14C are views showing an example of an image forming device using the light emitting device according to this embodiment;

Fig. 15 is a view showing an example of a display device using the light emitting device according to this embodiment;

Fig. 16 is a view showing an example of a photoelectric conversion device using the light emitting device according to this embodiment;

Fig. 17 is a view showing an example of an electronic apparatus using the light emitting device according to this embodiment;

Figs. 18A and 18B are views each showing an example of a display device using the light emitting device according to this embodiment;

Fig. 19 is a view showing an example of an illumination device using the light emitting device according to this embodiment;

Fig. 20 is a view showing an example of a moving body using the light emitting device according to this embodiment; and

Figs. 21A and 21B are views each showing an example of a wearable device using the light emitting device according to this embodiment.

## DESCRIPTION OF THE EMBODIMENTS

Hereinafter, embodiments will be described in detail with reference to the attached drawings. Note, the following embodiments are not intended to limit the scope of the claimed invention. Multiple features are described in the embodiments, but limitation is not made to an invention that requires all such features, and multiple such features may be combined as appropriate. Furthermore, in the attached drawings, the same reference numerals are given to the same or similar configurations, and redundant description thereof is omitted.

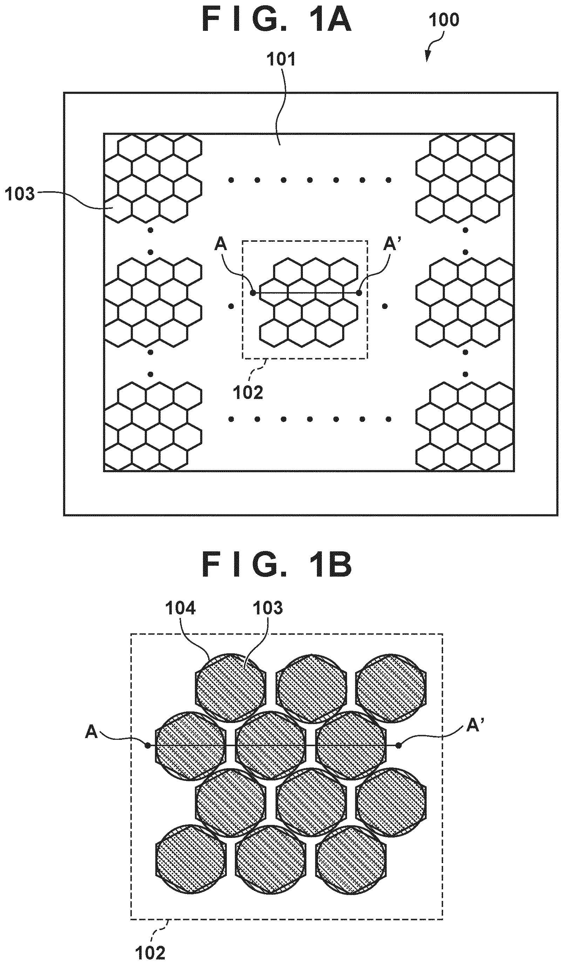

With reference to Figs. 1A to 12, a light emitting device according to an embodiment of the present disclosure will be described. According to the present disclosure, for light emitting elements having a light extraction structure, the resonant peak wavelength in the normal direction of the main surface of a substrate is set larger than the peak wavelength of the emission spectrum in each of a green light emitting element and a blue light emitting element. Further, the difference between the resonant peak wavelength and the peak wavelength of the emission spectrum in the green light emitting element is set larger than the difference between the resonant peak wavelength and the peak wavelength of the emission spectrum in the blue light emitting element. With this, a color shift on the wide-angle side, where the viewing angle upon viewing the light emitting element increases, is shifted toward the blue side along the black body locus. As a result, the visibility of a white color shift on the wide-angle side can be lowered.

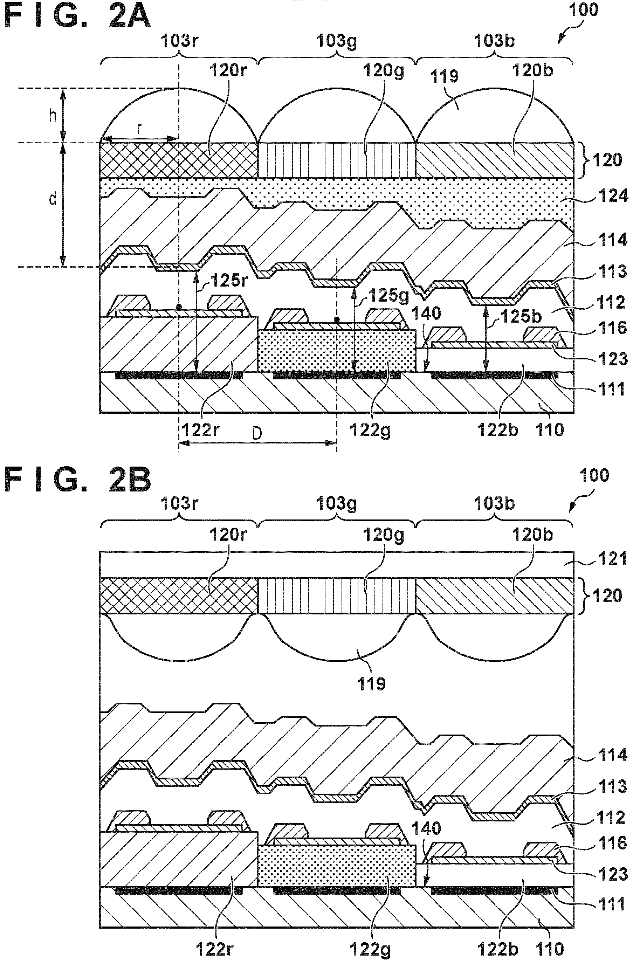

Figs. 1A and 1B are plan views of a light emitting device 100 according to this embodiment, and Figs. 2A and 2B are sectional views of the light emitting device 100. In the light emitting device 100, a plurality of light emitting elements 103, each of which includes an organic layer 112 including a light emitting layer and a light extraction structure 104 (for example, microlens 119) arranged so as to cover the organic layer 112, are arranged on a main surface 140 of a substrate 110. When the light emitting elements 103 which emit light components of different colors are arranged, the light emitting device 100 functions as, for example, a display device that displays an image or the like. The light emitting device 100 includes a display region 101 in which the light emitting elements 103 are arranged in a two-dimensional array. The array of the light emitting elements 103 shown in Fig. 1A is a delta array, but may be a stripe array, a square array, a pentile array, a Bayer array, or the like. A central portion 102 of the display region 101 is indicated by a dashed line in Fig. 1A.

Fig. 1B is an enlarged view of the central portion 102 shown in Fig. 1A. In the arrangement shown in Fig. 1B, in an orthogonal projection to the main surface 140 of the substrate 110, the center of the light emitting region of the light emitting element 103 matches the center of the light extraction structure 104. In this embodiment, the light emitting region of the light emitting element 103 has a hexagonal shape, but the shape of the light emitting region is not limited to the hexagonal shape. If the shape of the light emitting region is a polygon, the center of the light emitting region of the light emitting element 103 may be the center of the inscribed circle of the polygon. If the shape of the light emitting region is a circle, the center of the light emitting region of the light emitting element 103 may be the center of the circle.

Fig. 2A is a sectional view taken along a line A - A' shown in Figs. 1A and 1B. Here, the sectional view is an arrangement diagram showing the section of the light emitting device 100 in the normal direction with respect to the main surface 140 of the substrate 110. Fig. 2A shows an example in which the microlens 119 having a shape protruding in the normal direction of the main surface 140 of the substrate 110 is arranged as the light extraction structure 104 of the light emitting device 100. The light emitting device 103 includes, on the substrate 110, a reflective electrode 111, the organic layer 112 including the light emitting layer, a semi-transmissive electrode 113, a protection layer 114, and the microlens 119 in this order. In this embodiment, the light emitting element 103 is a so-called organic electroluminescence (EL) element. However, the light emitting element 103 is not limited to the organic EL element, and may be an inorganic EL element, a semiconductor laser element, a light emitting diode (LED), or the like.

The reflective electrode 111 and the semi-transmissive electrode 113 can also be referred to as a lower electrode and an upper electrode, respectively, because of their arrangement positions. The light emitting element 103 has a resonant structure that strengthens light emission by an optical distance 125 between the reflective electrode 111 and the semi-transmissive electrode 113. In accordance with the light emission color of each of a red light emitting element 103r, a green light emitting element 103g, and a blue light emitting element 103b, each of optical distances 125r, 125g, and 125b is set to strengthen a desired wavelength.

If the organic layer 112 including the light emitting layer has a common film thickness over the light emitting elements 103 and the light emitting layer emits white light, the resonant structure can be optimized by the film thickness of a transparent electrode 123 electrically connected to each of optical adjustment layers 122r, 122g, and 122b and the reflective electrode 111. In this case, as shown in Fig. 2A, a color filter 120 may be provided between the protection layer 114 and the micro lens 119. However, the present invention is not limited to this, and a light emitting layer which emits light of a different color for each light emitting element 103 may be arranged in the organic layer 112. If a light emitting layer which emits light of a different color for each light emitting element 103 is arranged, the film thickness of the organic layer may be optimized for each light emitting element 103 without arranging the optical adjustment layers 122r, 122g, and 122b, and the color filters 120.

The light emitting device 100 includes an insulating layer 116 which functions as a bank for covering the outer edge portion of the transparent electrode 123 and exposing the central portion of the transparent electrode 123. The shape of the above-described light emitting region of the light emitting element 103 can be decided by the insulating layer 116.

Light emitted from the light emitting layer arranged in the organic layer 112 enters the microlens 119. The microlens 119 may have a shape protruding toward the main surface 140 of the substrate 110 as shown in Fig. 2B. In this case, the color filter 120 may be arranged between the microlens 119 and protective glass 121, or may be arranged between the microlens 119 and the protection layer 114.

The substrate 110 may be made of any material that can support respective components such as the reflective electrode 111, the organic layer 112, and the semi-transmissive electrode 113. As the substrate 110, for example, glass, plastic, silicon, or the like can be used. A switching element such as a transistor, a wiring pattern, an interlayer insulating layer, and the like may be arranged in the substrate 110.

For the reflective electrode 111, for example, a metal material having a reflectance of 70% or more with respect to the light emission wavelength of the light emitting layer arranged in the organic layer 112 can be used. The reflective electrode 111 may be made of a metal such as aluminum or silver, or an alloy obtained by adding silicon, copper, nickel, neodymium, or the like to the metal. Alternatively, the reflective electrode 111 may have a stacked structure of a barrier electrode and a metal such as titanium, tungsten, molybdenum, or gold or an alloy thereof, or may have a stacked structure including a transparent conductive oxide layer made of ITO or IZO, and the like, as long as the reflectance is higher than a desired reflectance.

As shown in Fig. 2A, the transparent electrode 123 electrically connected to the reflective electrode 111 is arranged above the reflective electrode 111. For the transparent electrode 123, for example, ITO, IZO, AZO, IGZO, or the like can be used. In Fig. 2A, for the purpose of optimizing the optical distance 125 in the light emitting element 103 for each color, the optical adjustment layer 122 is arranged between the reflective electrode 111 and the transparent electrode 123. As shown in Fig. 2A, the film thickness of each of the optical adjustment layers 122r, 122g, and 122b is optimized such that the interference condition for strengthening the light near the peak wavelength of the emission spectrum of each of the red light emitting element 103r, the green light emitting element 103g, and the blue light emitting element 103b is achieved. With this, the light emission intensity can be dramatically increased. In the arrangement shown in Fig. 2A, the peak wavelength of the emission spectrum of each of the red light emitting element 103r, the green light emitting element 103g, and the blue light emitting element 103b can be decided by the color filter 120. For example, a color filter 120r of the red light emitting element 103r may transmit light of 600 nm (inclusive) to 650 nm (inclusive), a color filter 120g of the green light emitting element 103g may transmit light of 500 nm (inclusive) to 550 nm (inclusive), and a color filter 120b of the blue light emitting element 103b may transmit light of 440 nm (inclusive) to 480 nm (inclusive). With this, the peak wavelength of the emission spectrum of the red light emitting element 103r can be 600 nm (inclusive) to 650 nm (inclusive), the peak wavelength of the emission spectrum of the green light emitting element 103g can be 500 nm (inclusive) to 550 nm (inclusive), and the peak wavelength of the emission spectrum of the blue light emitting element 103b can be 440 nm (inclusive) to 480 nm (inclusive). Furthermore, the peak wavelength of the emission spectrum of red may be 615 nm (inclusive) to 640 nm (inclusive), the peak wavelength of the emission spectrum of green may be 520 nm (inclusive) to 540 nm (inclusive), and the peak wavelength of the emission spectrum of blue may be 450 nm (inclusive) to 470 nm (inclusive).

The semi-transmissive electrode 113 is arranged on the organic layer 112 and has translucency. The semi-transmissive electrode 113 has a characteristic of transmitting part of light that has reached the surface of the semi-transmissive electrode 113 and reflecting the remaining part of the light (that is, a transflective property). As the semi-transmissive electrode 113, for example, a transparent material such as a transparent conductive oxide may be used. Alternatively, as the semi-transmissive electrode 113, aluminum, silver, gold, or the like, an alkali metal such as lithium or cesium, an alkaline earth metal such as magnesium, calcium, or barium, or an alloy containing these metals may be used. For example, for the semi-transmissive electrode 113, an alloy containing magnesium or silver as a main component can be used. The semi-transmissive electrode 113 may have a stacked structure including a layer containing the above-described material, as long as an appropriate transmittance is ensured. The semi-transmissive electrode 113 may be shared by the plurality of light emitting elements 103 as shown in Fig. 2A.

One of the reflective electrode 111 (and the transparent electrode 123) and the semi-transmissive electrode 113 functions as an anode, and the other functions as a cathode. That is, the reflective electrode 111 may be the anode and the semi-transmissive electrode 113 may be the cathode, and vice versa.

The organic layer 112 including the light emitting layer is arranged on the transparent electrode 123. The organic layer 112 can be formed by a known technique such as a vapor deposition method or a spin coating method. The organic layer 112 may be formed by a plurality of layers including the light emitting layer. Examples of the layers other than the light emitting layer included in the organic layer 112 are a hole injection layer, a hole transport layer, an electron blocking layer, a hole blocking layer, an electron transport layer, and an electron injection layer. The organic layer emits light when holes injected from the anode and electrons injected from the cathode recombine. The light emitting layer may have a single-layer structure or a stacked structure. The light emitting layer can contain a red light emitting material, a green light emitting material, and a blue light emitting material, and the light emission colors can be mixed to obtain while light. In addition, the light emitting layer may contain light emitting materials having a complimentary color relationship, such as a blue light emitting material and a yellow light emitting material. The light emitting material may be a material such as a fluorescent material, a phosphorescent material, or a delayed fluorescence material, or may be a quantum dot of CdS, perovskite, or the like. The material and composition of the light emitting layer may be different for each of the light emitting elements 103 of different light emission colors. In this case, each light emitting element 103 may be provided with an independent light emitting layer. For example, the organic layer 112 is formed by patterning the light emitting layer for each light emitting element 103.

The protection layer 114 may be an insulating layer containing an inorganic material which has translucency and low permeability to oxygen and water from the outside. For the protection layer 114, for example, silicon nitride, silicon oxynitride, silicon oxide, aluminum oxide, titanium oxide, or the like can be used. In terms of the protection performance, silicon nitride, silicon oxynitride, and aluminum oxide are suitable. A chemical vapor deposition (CVD) method, an atomic layer deposition (ALD) method, a sputtering method, or the like can be used to form the protection layer 114.

The protection layer 114 may have a single-layer structure or a stacked structure as long as sufficient water block performance is ensured. For example, the protection layer 114 may have a stacked structure of silicon nitride deposited using the CVD method and aluminum oxide deposited using the ALD method. The ALD method can form a layer having a high density. Furthermore, the protection layer 114 may include an organic layer as long as it has water block performance. As the organic layer, for example, a layer using polyacrylate, polyamide, polyester, epoxy, or the like can be used. Furthermore, as shown in Fig. 2A, the protection layer 114 may be arranged over the plurality of light emitting elements 103. For the purpose of planarizing the unevenness of the upper surface of the protection layer 114, a planarizing layer may be arranged between the protection layer 114 and the microlens 119. The color filter 120 can be arranged between the microlens 119 and the protection layer 114 or between the microlens 119 and the planarizing layer.

The microlens 119 can be formed by an exposure process and a developing process. More specifically, a material film (photoresist film) for forming the microlens 119 is formed, and the material film is exposed and developed using a mask including a continuous change in gradation. As the mask, a gray mask or an area gradation mask can be used. The area gradation mask enables light irradiation having continuous gradations on the imaging plane by changing the density distribution of dots formed using a light shielding film with a resolution equal to or smaller than the resolution of an exposure apparatus.

The lens shape can be adjusted by etching back the microlens 119 formed using the exposure process and the developing process. The shape of the microlens 119 need only have a shape that can refract radiation light, and may be spherical or have an asymmetrical sectional shape. The effect of the present disclosure is not limited to the microlens 119 as shown in Figs. 2A and 2B. That is, the microlens 119 need only have a certain inclination angle with respect to the main surface 140 of the substrate 110, and may be an aspherical microlens, a conical microlens, a cylindrical microlens, a digital microlens, or the like.

Next, the effect of this embodiment will be described. First, a definition of the interference peak wavelength (resonant wavelength) is given. It has been known that the light emission efficiency significantly changes depending on the optical interference condition in the light emitting element 103. Strengthening the optical interference condition means setting the interference for strengthening radiation by adjusting a distance $d_0$ from the light emission position of the light emitting layer of the organic layer 112 to the reflection surface of the reflective material to $d_0 = m\lambda/4n_0$ (m = 1, 3, 5,....) As a result, components in a specific direction increase in the radiation distribution of light of a wavelength $\lambda$, and the radiance at a specific angle improves. Here, $n_0$ is the effective refractive index of the wavelength $\lambda$ in the layer from the light emission position to the reflection surface.

More specifically, letting $\varphi r$ [rad] be the sum of the phase shift amounts when light of the wavelength $\lambda$ is reflected on the reflection surface of the reflective electrode 111, and $\theta eml$ [°] be the radiation angle in the light emitting layer with respect to the normal direction of the main surface 140 of the substrate 110, an optical distance Lr that strengthens the optical interference condition between the light emission position and the reflection surface of the reflective electrode 111 is expressed by the following equation (1). Here, the optical distance Lr is the total sum of products each obtained from a refractive index $n_j$ and a thickness $d_j$ of each layer between the light emitting layer of the organic layer 112 and the reflective electrode 111. That is, Lr can be expressed as $\Sigma n_j \times d_j$. Further, letting di be the distance from the light emitting layer of the organic layer 112 to the reflective electrode 111 and $n_1$ be the effective refractive index of the wavelength $\lambda$, Lr can also be expressed as $n_1 \times$ di. Here, $\varphi r$ is a negative value.

$$Lr(\theta eml) = (2m - (\varphi r/\pi)) \times (\lambda/4) \times 1/\cos\theta eml \qquad ...(1)$$

In equation (1), m is the interference order between the light emission point and the reflective electrode 111, and is an integer of 0 or more. In the ideal case where $\varphi r = \pi$, a case where m = 0 and a case where m = 1 are called a $\lambda/4$ interference condition and a $3\lambda/4$ interference condition, respectively.

This also applies to the interference condition for an optical distance Ls from the light emitting layer of the organic layer 112 to the semi-transmissive electrode 113. Accordingly, an optical distance L that strengthens the optical interference condition from the reflective electrode 111 to the semi-transmissive electrode 113 is expressed as:

$$L(\theta eml) = (Lr + Ls) = (2M - \Phi/\pi) \times (\lambda/4) \times 1/\cos\theta eml \qquad ...(2)$$

where M is the sum of the interference order m between the light emitting layer of the organic layer 112 and the reflective electrode 111 and an interference order m' between the light emitting layer of the organic layer 112 and the semi-transmissive electrode 113 (M = m + m'), and is an integer of 0 or more. $\varphi$ is the sum of phase shifts when light of the wavelength $\lambda$ is reflected by the reflective electrode 111 and the semi-transmissive electrode 113 ($\varphi = \varphi r + \varphi s$) ($\varphi s$ [rad] : the sum of phase shift amounts when light of the wavelength $\lambda$ is reflected on the reflection surface of the semi-transmissive electrode 113).

When the light emitting element does not have the inclined surface of the light extraction structure 104 such as the microlens 119, the film thickness of each layer between the reflective electrode 111 and the semi-transmissive electrode 113 is often designed so as to satisfy equations (1) and (2) in the normal direction of the main surface 140 of the substrate 110, that is, under the condition of $\theta eml = 0°$. Letting $\lambda on$ be the resonant peak wavelength in the normal direction in this case:

$$\lambda on = 4\pi L(0)/(2\pi M - \Phi) \qquad ...(3)$$

where L(0) is a whole layer interference length at Semi = 0°. Usually, in the light emitting element that does not have the inclined surface of the light extraction structure 104 such as the microlens 119, the resonant peak wavelength $\lambda on$ in the normal direction expressed by equation (3) is designed to approximately match the peak wavelength $\lambda$ of the emission spectrum of the light emitting element (for example, the light emitting dopant of the light emitting layer). Here, let $\Delta$ be a value obtained by subtracting the peak wavelength $\lambda$ of the emission spectrum from the resonant peak wavelength $\lambda on$ ($\Delta = \lambda on - \lambda$). Accordingly, in the light emitting element including no light extraction structure 104, it is often designed to satisfy $\Delta = \lambda on - \lambda = 0$.

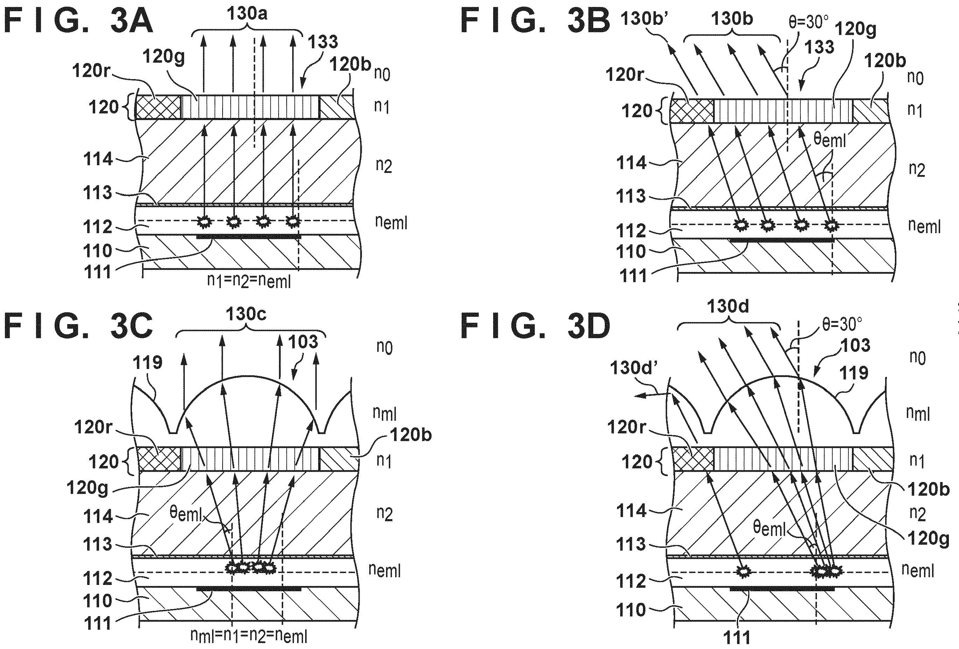

Next, it will be explained that the light emitting element 103 in which the light extraction structure 104 such as the microlens 119 is arranged has different viewing angle characteristics compared to the light emitting element in which the light extraction structure 104 is not arranged. Figs. 3A to 3D are views each showing a relationship between a light ray angle $\theta$ outside the light emitting element 103 and a light ray angle Semi inside the light emitting element 103. Figs. 3A and 3B are views showing the relationship of the light ray angle of a light ray 130a and that of a light ray 130b, respectively, in a light emitting element 133 of a comparative example in which the light extraction structure 104 is not arranged. Figs. 3C and 3D are views showing the relationship of the light ray angle of a light ray 130c and that of a light ray 130d, respectively, in the light emitting element 103 of this embodiment in which the microlens 119 is arranged as the light extraction structure 104. Fig. 3A shows a case where the light ray angle $\theta$ is 0° outside the light emitting element 133, Fig. 3B shows a case where the light ray angle $\theta$ is 30° outside the light emitting element 133, Fig. 3C shows a case where the light ray angle $\theta$ is 0° outside the light emitting element 103, and Fig. 3D shows a case where the light ray angle $\theta$ is 30° outside the light emitting element 103. For the sake of simplicity, it is assumed here that a refractive index $n_{eml}$ of the organic layer 112 including the light emitting layer, a refractive index $n_2$ of the protection layer 114, a refractive index $n_1$ of the color filter 120, and a refractive index $n_{ml}$ of the microlens 119 are equal to each other ($n_{ml} = n_1 = n_2 = n_{eml}$).

In the case where no light extraction structure is arranged, like the light emitting element 133, the light ray angle θeml inside the light emitting element 133 has no distribution, as shown in Figs. 3A and 3B. On the other hand, in the case where the microlens 119 is arranged as the light extraction structure 104, the light ray angle θeml inside the light emitting element 103 has a distribution in accordance with the shape parameter (the distribution of the inclined angle) of the microlens 119, as shown in Figs. 3C and 3D.

Furthermore, as shown in Fig. 3B, in the case where the light extraction structure 104 is not arranged, a light ray 130b' that passes through the color filter of the adjacent light emitting element 133 and becomes a mixed color component is generated. On the other hand, in the case of the light emitting element 103 arranged with the microlens 119, as shown in Fig. 3D, a light ray 130d' passing through the color filter 120 of the adjacent light emitting element 103 is totally reflected by the microlens 119 and is not emitted to the outside. Due to this difference, the interference design for suppressing color shifts changes between the case where the light extraction structure 104 such as the microlens 119 is arranged and the case where the light extraction structure 104 is not arranged.

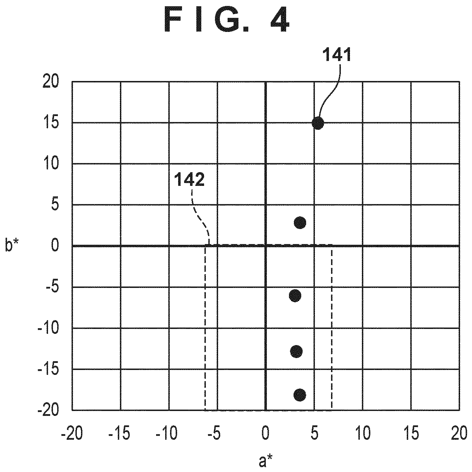

Next, a method of suppressing the visibility of a color shift will be explained. In order to suppress the visibility of a color shift, the chromaticity change of white should be shifted toward the blue side along the black body locus. Fig. 4 shows a black body locus 141 in an a*b* space where a reference white point (origin) is D65. Here, for the sake of simplicity, the a*b* space is used, but an u'v' space or an xy space may also be used. A condition for lowering the visibility of a color shift, that is, a condition for causing a color shift toward the blue side along the black body locus 141 corresponds to a visibility lowering region 142 shown in Fig. 4. More specifically, |a*| is 5 or less, and b* is 0 or less. That is, in the light emitting device 100 with the lowered color shift visibility, the plurality of light emitting elements 103 each including the light emitting layer and the light extraction structure 104 arranged so as to cover the light emitting layer are arranged on the main surface 140 of the substrate 110, and the plurality of light emitting elements 103 include the red light emitting element 103r that emits red light, the green light emitting element 103g that emits green light, and the blue light emitting element 103b that emits blue light, and include a resonant structure corresponding to each light emission color. In this case, it can also be said that, in the light emitting device 100, when emitting white light, the color shift between light emission in the normal direction of the main surface 140 of the substrate 110 and light emission in a direction of 30° with respect to the normal direction of the main surface 140 of the substrate 110 in the a*b* space falls within a range of |a*| ≤ 5.0 and b* ≤ 0. In order to lower the visibility of a color shift, the absolute value of the color shift is ideally decreased. However, considering other conditions such as the light extraction efficiency, it is sometimes difficult to decrease the absolute value of the color shift. In that case, by shifting the color shift toward the blue side corresponding to the visibility lowering region 142, the visibility of the color shift can be lowered.

The inventors made various examinations and found that the visibility of a color shift is suppressed in the light emitting element 103 including the light extraction structure 104 such as the microlens 119 by satisfying:

$$\Delta g = \lambda on\_g - \lambda g > 0 \ [\text{nm}] \qquad ...(4)$$

$$\Delta b = \lambda on\_b - \lambda b > 0 \ [\text{nm}] \qquad ...(5)$$

$$\Delta g - \Delta b \geq 0 \ [\text{nm}] \qquad ...(6)$$

Here, λon_g [nm] is the resonant peak wavelength in the normal direction of the main surface 140 of the substrate 110 in the resonant structure of the green light emitting element 103g. λg [nm] is the peak wavelength of the emission spectrum of the green light emitting element 103g. λon_b [nm] is the resonant peak wavelength in the normal direction of the main surface 140 of the substrate 110 in the resonant structure of the blue light emitting element 103b. λb [nm] is the peak wavelength of the emission spectrum of the blue light emitting element 103b.

The following expression may also be satisfied:

$$15 \ [\text{nm}] \geq \Delta g - \Delta b \geq 0 \ [\text{nm}] \qquad ...(7)$$

Furthermore, Δb obtained by subtracting the peak wavelength λb of the emission spectrum from the resonant peak wavelength λon_b of the blue light emitting element 103b may satisfy:

$$17 \ [\text{nm}] \geq \Delta b > 0 \ [\text{nm}] \qquad ...(8)$$

Furthermore, Δg obtained by subtracting the peak wavelength λg of the emission spectrum from the resonant peak wavelength λon_g of the green light emitting element 103g may satisfy:

$$20 \, [\text{nm}] \geq \Delta g \geq 10 \, [\text{nm}] \qquad\qquad ...(9)$$

When these conditions are satisfied, the visibility of a color shift can be suppressed. Examples and comparative examples will be described later.

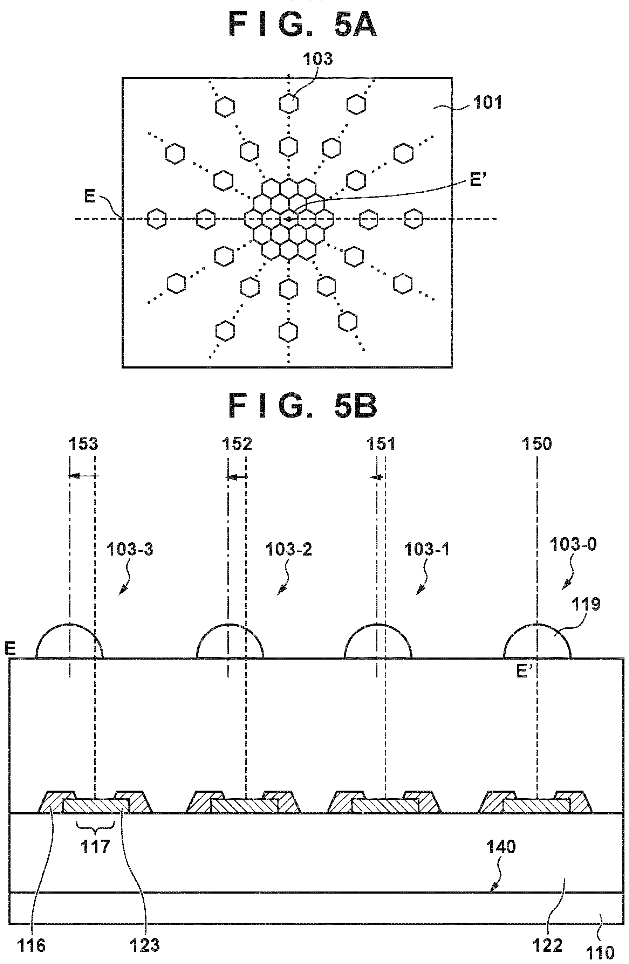

Here, with reference to Figs. 5A and 5B, the relationship between the center position of the microlens 119 serving as the light extraction structure 104 and the center position of a light emitting region 117 of the light emitting element 103 in the display region 101 where the plurality of light emitting elements 103 are arranged will be explained. The light emitting region 117 can be a portion of the transparent electrode 123 uncovered with the insulating layer 116.

Figs. 5A and 5B are a plan view and a sectional view exemplifying the microlens 119 as an example of the light extraction structure 104, and illustrating the relationship between the microlens 119 and the light emitting region 117 between E and E' in the display region 101. E' indicates the center of the display region 101. The plurality of light emitting elements 103 arranged in the display region 101 include light emitting elements 103_1 to 103_3 arranged between the center E' and the outer edge E of the display region 101. In the orthogonal projection to the main surface 140 of the substrate 110, the center of the microlens 119 arranged in each of the light emitting elements 103_1 to 103_3 may be arranged between the center of the light emitting region 117 of each of the light emitting elements 103_1 to 103_3 where light is emitted and the center E' of the display region 101. For example, consider the light emitting elements 103_1 and 103_2 arranged between the center E' of the display region 101 and the light emitting element 103_3. In the orthogonal projection to the main surface 140 of the substrate 110, a shift amount 153 between the center of the light emitting region 117 and the center of the microlens 119 in the light emitting element 103_3 may be larger than a shift amount 151 between the center of the light emitting region 117 and the center of the microlens 119 in the light emitting element 103_1 and a shift amount 152 therebetween in the light emitting element 103_2. Further, in the orthogonal projection to the main surface 140 of the substrate 110, the center of the microlens 119 arranged in a light emitting element 103_0 arranged at the center E' of the display region 101 may overlap the center of the light emitting region 117 of the light emitting element 103_0 where light is emitted.

As shown in Fig. 5B, the light emitting regions 117 and the microlenses 119 may be arranged such that the shift amounts 151, 152, and 153 each between the center of the light emitting region 117 and the center of the microlens 119 increase from the center E of the display region 101 toward the outer edge E. However, the present invention is not limited to this, and the shift amounts 151 to 153 each between the center of the light emitting region 117 and the center of the microlens 119 may be constant. In addition, as has been described above, a shirt amount 150 between the center of the light emitting region 117 and the center of the microlens 119 of the light emitting element 103_0 arranged at the center E' of the display region 101 may be 0. However, the present invention is not limited to this, and the center of the light emitting region 117 may be shifted from the center of the microlens 119 in the light emitting element 103_0 arranged at the center E' of the display region 101. Alternatively, for example, the shift amounts 150 to 153 each obtained between the center of the light emitting region 117 and the center of the microlens 119 may be constant (for example, 0 or the like).

The shift amounts 150 to 153 may be formed so as to continuously change macroscopically with respect to the position of the light emitting element 103 in the display region 101. The shift amounts 150 to 153 may continuously change macroscopically, and the shift amounts 150 to 153 may be changed for each light emitting element 103 or may be changed stepwise for each predetermined range. Alternatively, the shift amounts 150 to 153 may be changed for each light emitting element 103 in some regions, and may be changed stepwise for each predetermined range in some other regions.

As has been described above, Δg obtained by subtracting the peak wavelength λg of the emission spectrum from the resonant peak wavelength λon_g of the green light emitting element 103g and Δb obtained by subtracting the peak wavelength λb of the emission spectrum from the resonant peak wavelength λon_b of the blue light emitting element 103b are set to 0 or more, and Δg is set to be larger than Δb. With this, the visibility of a white color shift on the wide-angle side where the viewing angle increases can be lowered.

Next, a specific effect of this embodiment will be described with reference to examples. In this examination, the light emitting elements 103 as shown in Fig. 2A were used. As has been described above, the effect of this embodiment may be obtained in the arrangement where the organic layer 112 including the light emitting layer is patterned for each light emitting element 103. Alternatively, the light emitting element 103 where the light emitting layer emits light of an appropriate color and the color filter 120 is not arranged may be used.

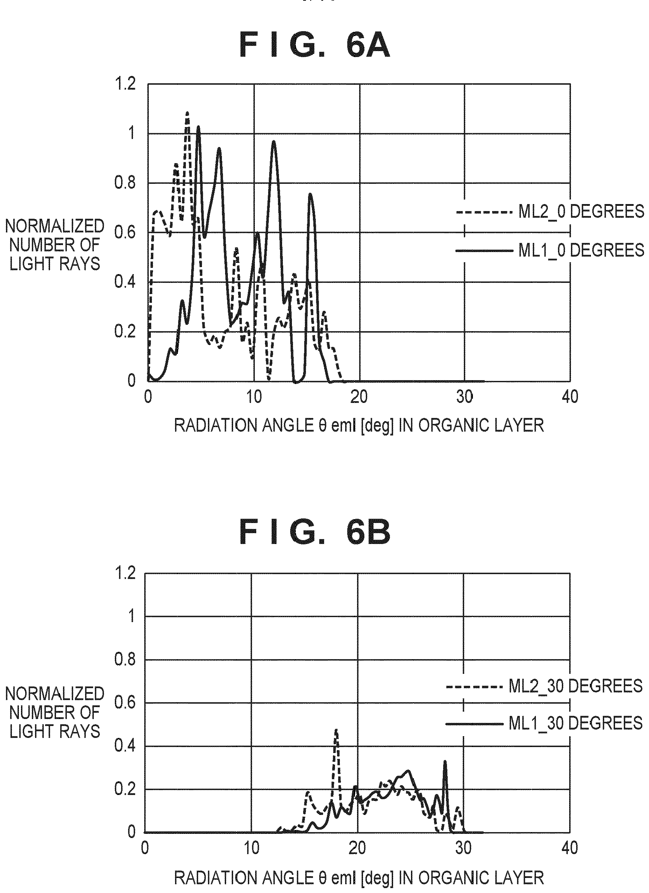

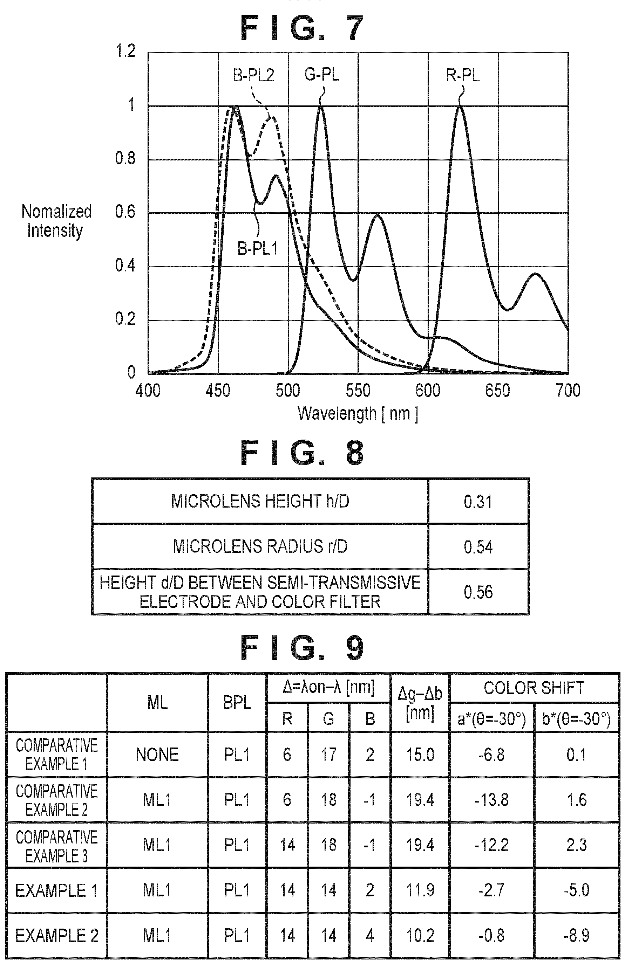

Fig. 8 shows shape parameters of the light emitting element 103 considered in this example. The shape parameters include a height h/D and a radius r/D of the microlens 119 and a height diD between the semi-transmissive electrode 113 and the color filter 120, which are normalized by an arrangement pitch D of the light emitting element 103. When light ray tracing (Zemax) was executed using the arrangement shown in Figs. 2A and 8, the distribution of the radiation angle, inside the organic light emitting element, of the light ray emitted in the normal direction (θ = 0°) of the main surface 140 of the substrate 110 and that of the light ray emitted at θ = 30° had characteristics indicated by ML1 in Figs. 6A and 6B, respectively.

Fig. 9 shows examination results. An Al electrode was used as the reflective electrode 111, MgAg of 15 nm was used as the semi-transmissive electrode 113, and nitride silicon was used as the protection layer 114. The microlens 119 was formed using a material having a refractive index n = 1.5. Fig. 7 shows an emission spectrum PL1 of the light emission dopant used in this example. R-PL1, G-PL1, and B-PL1 indicate the emission spectrums of red, green, and blue, respectively, and had peak wavelengths of 623 nm, 523 nm, and 462 nm, respectively.

Fig. 9 shows the value of $\Delta$ obtained by subtracting the peak wavelength $\lambda$ of the emission spectrum from the resonant peak wavelength $\lambda$on of the resonant structure expressed by equation (3) described above, and the value of the difference $\Delta g - \Delta b$ between $\Delta g$ of the green light emitting element 103g and $\Delta b$ of the blue light emitting element 103b. a* and b* representing a color shift shown in Fig. 9 represent the color shift at θ = 30° with respect to the normal direction which occurred when displaying the reference white point (D65) in the normal direction of the main surface 140 of the substrate 110.

Comparative Example 1 is an arrangement without the microlens 119, and it was found that conditional expressions (4) to (9) for $\Delta$ were satisfied but a* = -6.8 so that a color shift toward the green side occurred. That is, the visibility of the color shift is high. Each of Comparative Examples 2 and 3 is an arrangement including the microlens 119 but not satisfying conditional expression (5) for $\Delta b$ of the blue light emitting element 103b. As can be seen from Fig. 9, regardless of the value of $\Delta r$ of the red light emitting element 103r, a* became large as -13.8 and -12.2 so that a color shift toward the green side occurred. Thus, it was found that the visibility of the color shift is high.

Each of Examples 1 and 2 is an arrangement including the microlens 119 and satisfying conditional expressions (4) to (9) for $\Delta$. Example 1 is different from Example 2 in the value of $\Delta b$ of the blue light emitting element 103b, which is 2 in Example 1 and 4 in Example 2. In both Examples 1 and 2, the value of a* became small as -2.7 and -0.8, respectively, and b* was -5.0 and -8.9, respectively. That is, it can be seen that a color shift toward the blue side occurred. In this manner, in the light emitting element 103 in which the light extraction structure 104 such as the microlens 119 is arranged, the optical interference of the light emitting element 103 is adjusted so as to satisfy conditional expressions (4) to (9) for $\Delta$. With this, it was found that the visibility of the color shift on the wide-angle side where the viewing angle increases can be suppressed.

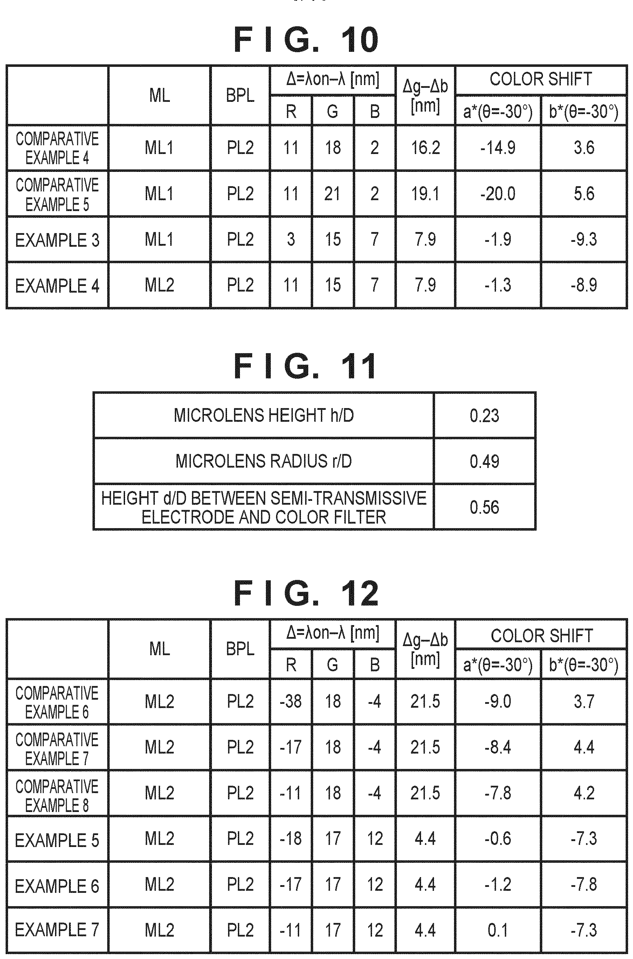

Fig. 10 shows results obtained when the light emitting dopant used for the blue light emitting element 103b was changed from the examples shown in Fig. 9. Fig. 7 shows an emission spectrum B-PL2 of the light emission dopant used for the blue light emitting element 103b. The remaining configurations of the light emitting element 103 such as the material and interference condition are similar to those in the examples shown in Fig. 9. As in the results shown in Fig. 9, a* and b* representing a color shift represent the color shift at θ = 30° with respect to the normal direction which occurred when displaying the reference while point (D65) in the normal direction of the main surface 140 of the substrate 110.

Each of Comparative Examples 4 and 5 is a light emitting element including the microlens. Comparative Example 4 shows the color shift value under a condition not satisfying conditional expression (7) for $\Delta$, and Comparative Example 5 shows the color shift value under a condition not satisfying conditional expressions (7) and (9) for $\Delta$. In Comparative Examples 4 and 5, the values of a* are -14.9 and -20, respectively, so that it was found that a color shift toward the green side occurred. That is, the visibility of the color shift is high. On the other hand, each of Examples 3 and 4 is an arrangement including the microlens and satisfying conditional expressions (4) to (9) for $\Delta$. In Examples 3 and 4, the values of $\Delta r$ of the red light emitting elements 103r are 3 and 11, respectively. In Examples 3 and 4, regardless of $\Delta r$ of the red light emitting element 103r, the values of a* are -1.9 and -1.3, respectively, so that the absolute value of a* decreased. On the other hand, the values of b* are -9.3 and -8.9, respectively, so that it was found that the color shift toward the blue side occurred. From above, it was found that, regardless of the shape of the emission spectrum of the blue light emitting element 103b, when expressions (4) to (9) for the interference condition of the light emitting element 103 are satisfied, the visibility of the color shift can be lowered.

Next, examination results obtained when the shape of the microlens 119 was changed will be described. Fig. 11 shows shape parameters of the light emitting element 103 considered in this example. When light ray tracing (Zemax) was executed using the arrangement shown in Figs. 2A and 11, the distributions of the radiation angle, inside the organic light emitting element, of the light ray emitted in the normal direction (θ = 0°) of the main surface 140 of the substrate 110 and that of the light ray emitted at θ = 30° have characteristics indicated by ML2 in Figs. 6A and 6B.

Fig. 12 shows examination results obtained when the microlens 119 shown in Fig. 11 was used. The remaining configurations of the light emitting element 103 such as the material and interference condition are similar to those in the examples shown in Figs. 9 and 10. As in the results shown in Figs. 9 and 10, a* and b* representing a color shift represent the color shift at θ = 30° with respect to the normal direction which occurred when displaying the reference white point (D65) in the normal direction of the main surface 140 of the substrate 110.

Each of Comparative Examples 6 to 8 is a light emitting element including the microlens 119 but not satisfying conditional expression (5) for Δ. The values of Δr of the red light emitting elements 103r are -38, -17, and -11 in Comparative Examples 6 to 8, respectively. As can be seen from Fig. 12, regardless of the value of Δr of the red light emitting element 103r, the values of a* became large as -9.0, -8.4, and -7.8, respectively, so that it was found that a color shift toward the green side occurred.

On the other hand, each of Examples 5 to 7 is a light emitting element including the microlens 119 and satisfying the above-described conditional expressions (4) to (9) for Δ. As can be seen from Fig. 12, in Examples 5 to 7, regardless of the value of Δr of the red light emitting element 103r, the values of a* were -0.6, -1.2, and -0.1 and the values of b* were -7.3, -7.8, and -7.3, respectively. That is, it was found that the color shift toward the blue side occurred so that the visibility of the color shift was low.

From above, it became clear that, regardless of the shape of the microlens 119, when the relational expressions for the interference condition of the light emitting element 103 are satisfied, the visibility of the color shift can be lowered. For example, in a wearable device such as a head mounted display, in design, the central portion of the display region 101 mainly uses light in the normal direction of the main surface 140 of the substrate 110, and the outer peripheral region of the display region 101 mainly uses light on the wide-angle side since the outer peripheral region is relatively close to eyes. Even in such a case, by satisfying the above-described expressions (4) to (6) and further satisfying expressions (7) to (9) described in this embodiment, it can be suppressed that a color shift is visually recognized in one viewing field.

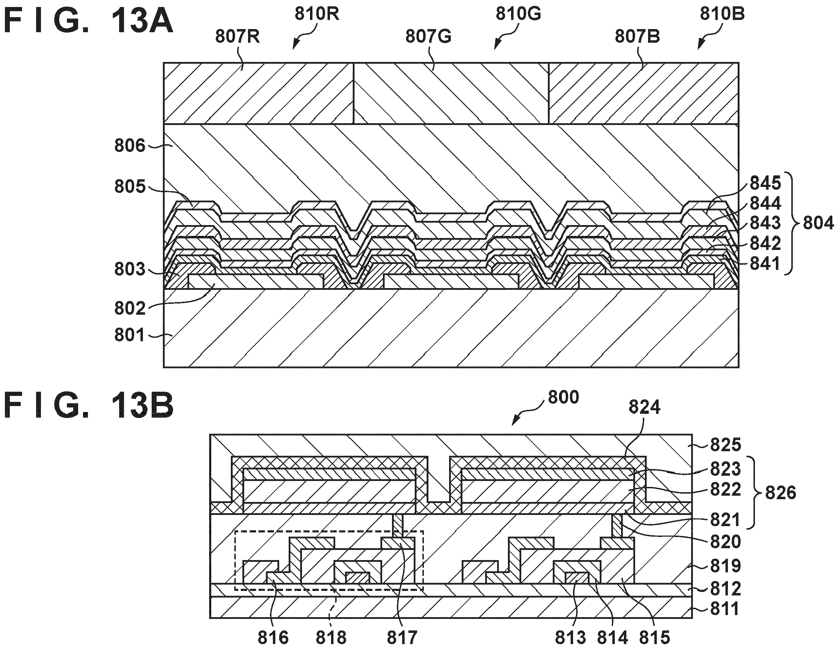

Here, application examples in which the light emitting device 100 according to this embodiment is applied to an image forming device, a display device, a photoelectric conversion device, an electronic apparatus, an illumination device, a moving body, and a wearable device will be described with reference to Figs. 13A to 21B. The description will be given assuming that, for example, an organic light emitting element such as an organic EL element is arranged as the light emitting element 103 in the display region 101 of the light emitting device 100 as has been described above. Details of each component arranged in the display region 101 of the light emitting device 100 described above will be described first, and the application examples will be described after that. In the following description, the above-described light emitting element 103 is sometimes referred to as the "pixel" or "sub-pixel".

Arrangement of Organic Light Emitting Element

The organic light emitting element is provided by forming an insulating layer, a first electrode, an organic compound layer, and a second electrode on a substrate. A protection layer, a color filter, a microlens, and the like may be provided on a cathode. If a color filter is provided, a planarizing layer may be provided between the protection layer and the color filter. The planarizing layer can be formed using acrylic resin or the like. The same applies to a case where a planarizing layer is provided between the color filter and the microlens.

Substrate

Quartz, glass, a silicon wafer, a resin, a metal, or the like may be used as a substrate. Furthermore, a switching element such as a transistor, a wiring pattern, and the like may be provided on the substrate, and an insulating layer may be provided thereon. The insulating layer may be made of any material as long as a contact hole can be formed so that the wiring pattern can be formed between the first electrode and the substrate and insulation from the unconnected wiring pattern can be ensured. For example, a resin such as polyimide, silicon oxide, silicon nitride, or the like may be used for the insulating layer.

Electrode

A pair of electrodes can be used as the electrodes. The pair of electrodes can be an anode and a cathode. If an electric field is applied in the direction in which the organic light emitting element emits light, the electrode having a high potential is the anode, and the other is the cathode. It can also be said that the electrode that supplies holes to the light emitting layer is the anode and the electrode that supplies electrons is the cathode.

As the constituent material of the anode, a material having a large work function may be selected. For example, a metal such as gold, platinum, silver, copper, nickel, palladium, cobalt, selenium, vanadium, or tungsten, a mixture containing some of them, an alloy obtained by combining some of them, or a metal oxide such as tin oxide, zinc oxide, indium oxide, indium tin oxide (ITO), or zinc indium oxide can be used. Furthermore, a conductive polymer such as polyaniline, polypyrrole, or polythiophene can also be used as the constituent material of the anode.

One of these electrode materials may be used singly, or two or more of them may be used in combination. The anode may be formed by a single layer or a plurality of layers.

If the electrode is used as a reflective electrode, for example, chromium, aluminum, silver, titanium, tungsten, molybdenum, an alloy thereof, a stacked layer thereof, or the like can be used. The above materials can function as a reflective film having no role as an electrode. If a transparent electrode is used as the electrode, an oxide transparent conductive layer made of indium tin oxide (ITO), indium zinc oxide, or the like can be used, but the present invention is not limited thereto. A photolithography technique can be used to form the electrode.

On the other hand, as the constituent material of the cathode, a material having a small work function may be selected. Examples of the material include an alkali metal such as lithium, an alkaline earth metal such as calcium, a metal such as aluminum, titanium, manganese, silver, lead, or chromium, and a mixture containing some of them. Alternatively, an alloy obtained by combining these metals can also be used. For example, a magnesium-silver alloy, an aluminum-lithium alloy, an aluminum-magnesium alloy, a silver-copper alloy, a zinc-silver alloy, or the like can be used. A metal oxide such as indium tin oxide (ITO) can also be used. One of these electrode materials may be used singly, or two or more of them may be used in combination. The cathode may have a single-layer structure or a multilayer structure. Silver may be used as the cathode. To suppress aggregation of silver, a silver alloy may be used. The ratio of the alloy is not limited as long as aggregation of silver can be suppressed. For example, the ratio between silver and another metal may be 1 : 1, 3 : 1, or the like.

The cathode may be a top emission element using an oxide conductive layer made of ITO or the like, or may be a bottom emission element using a reflective electrode made of aluminum (Al) or the like, and is not particularly limited. The method of forming the cathode is not particularly limited, but if direct current sputtering or alternating current sputtering is used, the good coverage is achieved for the film to be formed, and the resistance of the cathode can be lowered.

Pixel Isolation Layer

A pixel isolation layer may be formed by a so-called silicon oxide, such as silicon nitride (SiN), silicon oxynitride (SiON), or silicon oxide (SiO), formed using a Chemical Vapor Deposition (CVD) method. To increase the resistance in the in-plane direction of the organic compound layer, the organic compound layer, especially the hole transport layer may be thinly deposited on the side wall of the pixel isolation layer. More specifically, the organic compound layer can be deposited so as to have a thin film thickness on the side wall by increasing the taper angle of the side wall of the pixel isolation layer or the film thickness of the pixel isolation layer to increase vignetting during vapor deposition.

On the other hand, the taper angle of the side wall of the pixel isolation layer or the film thickness of the pixel isolation layer can be adjusted to the extent that no space is formed in the protection layer formed on the pixel isolation layer. Since no space is formed in the protection layer, it is possible to reduce generation of defects in the protection layer. Since generation of defects in the protection layer is reduced, a decrease in reliability caused by generation of a dark spot or occurrence of a conductive failure of the second electrode can be reduced.

According to this embodiment, even if the taper angle of the side wall of the pixel isolation layer is not acute, it is possible to effectively suppress leakage of charges to an adjacent pixel. As a result of this consideration, it has been found that the taper angle of 60° (inclusive) to 90° (inclusive) can sufficiently reduce the occurrence of defects. The film thickness of the pixel isolation layer may be 10 nm (inclusive) to 150 nm (inclusive). A similar effect can be obtained in an arrangement including only pixel electrodes without the pixel isolation layer. However, in this case, the film thickness of the pixel electrode is set to be equal to or smaller than half the film thickness of the organic layer or the end portion of the pixel electrode is formed to have a forward tapered shape of less than 60°. With this, short circuit of the organic light emitting element can be reduced.

Furthermore, in a case where the first electrode is the cathode and the second electrode is the anode, a high color gamut and low-voltage driving can be achieved by forming the electron transport material and charge transport layer and forming the light emitting layer on the charge transport layer.

Organic Compound Layer

The organic compound layer may be formed by a single layer or a plurality of layers. If the organic compound layer includes a plurality of layers, the layers can be called a hole injection layer, a hole transport layer, an electron blocking layer, a light emitting layer, a hole blocking layer, an electron transport layer, and an electron injection layer in accordance with the functions of the layers. The organic compound layer is mainly formed from an organic compound but may contain inorganic atoms and an inorganic compound. For example, the organic compound layer may contain copper, lithium, magnesium, aluminum, iridium, platinum, molybdenum, zinc, or the like. The organic compound layer may be arranged between the first and second electrodes, and may be arranged in contact with the first and second electrodes.

Protection Layer

A protection layer may be provided on the cathode. For example, by adhering glass provided with a moisture absorbing agent on the cathode, permeation of water or the like into the organic compound layer can be suppressed and occurrence of display defects can be suppressed. Furthermore, as another embodiment, a passivation layer made of silicon nitride or the like may be provided on the cathode to suppress permeation of water or the like into the organic compound layer. For example, the protection layer can be formed by forming the cathode, transferring it to another chamber without breaking the vacuum, and forming silicon nitride having a thickness of 2 $\mu$m by the CVD method. The protection layer may be provided using an atomic layer deposition (ALD) method after deposition of the protection layer using the CVD method. The material of the protection layer by the ALD method is not limited but can be silicon nitride, silicon oxide, aluminum oxide, or the like. Silicon nitride may further be formed by the CVD method on the protection layer formed by the ALD method. The protection layer formed by the ALD method may have a film thickness smaller than that of the protection layer formed by the CVD method. More specifically, the film thickness of the protection layer formed by the ALD method may be 50% or less, or 10% or less of that of the protection layer formed by the CVD method.

Color Filter

A color filter may be provided on the protection layer. For example, a color filter considering the size of the organic light emitting element may be provided on another substrate, and the substrate with the color filter formed thereon may be bonded to the substrate with the organic light emitting element provided thereon. Alternatively, for example, a color filter may be patterned on the above-described protection layer using a photolithography technique. The color filter may be formed from a polymeric material.

Planarizing Layer

A planarizing layer may be arranged between the color filter and the protection layer. The planarizing layer is provided to reduce unevenness of the layer below the planarizing layer. The planarizing layer may be called a material resin layer without limiting the purpose of the layer. The planarizing layer may be formed from an organic compound, and may be made of a low-molecular material or a polymeric material. In consideration of reduction of unevenness, a polymeric organic compound may be used for the planarizing layer.

The planarizing layers may be provided above and below the color filter. In that case, the same or different constituent materials may be used for these planarizing layers. More specifically, examples of the material of the planarizing layer include polyvinyl carbazole resin, polycarbonate resin, polyester resin, ABS resin, acrylic resin, polyimide resin, phenol resin, epoxy resin, silicone resin, and urea resin.

Microlens

The organic light emitting device may include an optical member such as a microlens on the light emission side. The microlens can be made of acrylic resin, epoxy resin, or the like. The microlens can aim to increase the amount of light extracted from the organic light emitting device and control the direction of light to be extracted. The microlens can have a hemispherical shape. If the microlens has a hemispherical shape, among tangents contacting the hemisphere, there is a tangent parallel to the insulating layer, and the contact between the tangent and the hemisphere is the vertex of the microlens. The vertex of the microlens can be decided in the same manner even in an arbitrary sectional view. That is, among tangents contacting the semicircle of the microlens in a sectional view, there is a tangent parallel to the insulating layer, and the contact between the tangent and the semicircle is the vertex of the microlens.

Furthermore, the middle point of the microlens can also be defined. In the section of the microlens, a line segment from a point at which an arc shape ends to a point at which another arc shape ends is assumed, and the middle point of the line segment can be called the middle point of the microlens. A section for determining the vertex and the middle point may be a section perpendicular to the insulating layer.

The microlens includes a first surface including a convex portion and a second surface opposite to the first surface. The second surface can be arranged on the functional layer (light emitting layer) side of the first surface. For this arrangement, the microlens needs to be formed on the light emitting device. If the functional layer is an organic layer, a process which produces high temperature in the manufacturing step of the microlens may be avoided. In addition, if it is configured to arrange the second surface on the functional layer side of the first surface, all the glass transition temperatures of an organic compound forming the organic layer may be 100°C or more. For example, 130°C or more is suitable.

Counter Substrate

A counter substrate may be arranged on the planarizing layer. The counter substrate is called a counter substrate because it is provided at a position corresponding to the above-described substrate. The constituent material of the counter substrate can be the same as that of the above-described substrate. If the above-described substrate is the first substrate, the counter substrate can be the second substrate.

Organic Layer

The organic compound layer (hole injection layer, hole transport layer, electron blocking layer, light emitting layer, hole blocking layer, electron transport layer, electron injection layer, and the like) forming the organic light emitting element according to an embodiment of the present disclosure may be formed by the method to be described below.

The organic compound layer forming the organic light emitting element according to the embodiment of the present disclosure can be formed by a dry process using a vacuum deposition method, an ionization deposition method, a sputtering method, a plasma method, or the like. Instead of the dry process, a wet process that forms a layer by dissolving a solute in an appropriate solvent and using a well-known coating method (for example, a spin coating method, a dipping method, a casting method, an LB method, an inkjet method, or the like) can be used.

Here, when the layer is formed by a vacuum deposition method, a solution coating method, or the like, crystallization or the like hardly occurs and excellent temporal stability is obtained. Furthermore, when the layer is formed using a coating method, it is possible to form the film in combination with a suitable binder resin.

Examples of the binder resin include polyvinyl carbazole resin, polycarbonate resin, polyester resin, ABS resin, acrylic resin, polyimide resin, phenol resin, epoxy resin, silicone resin, and urea resin. However, the binder resin is not limited to them.

One of these binder resins may be used singly as a homopolymer or a copolymer, or two or more of them may be used in combination. Furthermore, additives such as a well-known plasticizer, antioxidant, and an ultraviolet absorber may also be used as needed.

Pixel Circuit

The light emitting device can include a pixel circuit connected to the light emitting element. The pixel circuit may be an active matrix circuit that individually controls light emission of the first and second light emitting elements. The active matrix circuit may be a voltage or current programing circuit. A driving circuit includes a pixel circuit for each pixel. The pixel circuit can include a light emitting element, a transistor for controlling light emission luminance of the light emitting element, a transistor for controlling a light emission timing, a capacitor for holding the gate voltage of the transistor for controlling the light emission luminance, and a transistor for connection to GND without intervention of the light emitting element.

The light emitting device includes a display region and a peripheral region arranged around the display region. The light emitting device includes the pixel circuit in the display region and a display control circuit in the peripheral region. The mobility of the transistor forming the pixel circuit may be smaller than that of a transistor forming the display control circuit.

The slope of the current-voltage characteristic of the transistor forming the pixel circuit may be smaller than that of the current-voltage characteristic of the transistor forming the display control circuit. The slope of the current-voltage characteristic can be measured by a so-called Vg-Ig characteristic.

The transistor forming the pixel circuit is a transistor connected to the light emitting element such as the first light emitting element.

Pixel

The organic light emitting device includes a plurality of pixels. Each pixel includes sub-pixels that emit light components of different colors. The sub-pixels may include, for example, R, G, and B emission colors, respectively.

In each pixel, a region also called a pixel opening emits light. The pixel opening can have a size of 5 $\mu$m (inclusive) to 15 $\mu$m (inclusive). More specifically, the pixel opening can have a size of 11 $\mu$m, 9.5 $\mu$m, 7.4 $\mu$m, 6.4 $\mu$m, or the like.

A distance between the sub-pixels can be 10 $\mu$m or less, and can be, more specifically, 8 $\mu$m, 7.4 $\mu$m, or 6.4 $\mu$m.

The pixels can have a known arrangement form in a plan view. For example, the pixels may have a stripe arrangement, a delta arrangement, a pentile arrangement, or a Bayer arrangement. The shape of each sub-pixel in a plan view may be any known shape. For example, a quadrangle such as a rectangle or a rhombus, a hexagon, or the like may be possible. A shape which is not a correct shape but is close to a rectangle is included in a rectangle, as a matter of course. The shape of the sub-pixel and the pixel arrangement can be used in combination.

Application of Organic Light Emitting Element of Embodiment of Present Disclosure

The organic light emitting element according to an embodiment of the present disclosure can be used as a constituent member of a display device or an illumination device. In addition, the organic light emitting element is applicable to the exposure light source of an electrophotographic image forming device, the backlight of a liquid crystal display device, a light emitting device including a color filter in a white light source, and the like.

The display device may be an image information processing device that includes an image input unit for inputting image information from an area CCD, a linear CCD, a memory card, or the like, and an information processing unit for processing the input information, and displays the input image on a display unit.

In addition, a display unit included in an image capturing device or an inkjet printer can have a touch panel function. The driving type of the touch panel function may be an infrared type, a capacitance type, a resistive film type, or an electromagnetic induction type, and is not particularly limited. The display device may be used for the display unit of a multifunction printer.

More details will be described next with reference to the accompanying drawings. Fig. 13A shows an example of a pixel (light emitting element 103) as a constituent element of the above-described display region 101. The pixel includes sub-pixels 810 (light emitting elements 103). The sub-pixels are divided into sub-pixels 810R, 810G, and 810B by emitted light components. The light emission colors may be discriminated by the wavelengths of light components emitted from the light emitting layers, or light emitted from each sub-pixel may be selectively transmitted or undergo color conversion by a color filter or the like. Each sub-pixel includes a reflective electrode 802 as the first electrode on an interlayer insulating layer 801, an insulating layer 803 covering the end of the reflective electrode 802, an organic compound layer 804 covering the first electrode and the insulating layer, a transparent electrode 805 as the second electrode, a protection layer 806, and a color filter 807.

The interlayer insulating layer 801 can include a transistor and a capacitive element arranged in the interlayer insulating layer 801 or a layer below it. The transistor and the first electrode can electrically be connected via a contact hole (not shown) or the like.

The insulating layer 803 can also be called a bank or a pixel isolation film. The insulating layer 803 covers the end of the first electrode, and is arranged to surround the first electrode. A portion of the first electrode where no insulating layer 803 is arranged is in contact with the organic compound layer 804 to form a light emitting region.

The organic compound layer 804 includes a hole injection layer 841, a hole transport layer 842, a first light emitting layer 843, a second light emitting layer 844, and an electron transport layer 845.

The second electrode may be a transparent electrode, a reflective electrode, or a semi-transmissive electrode.

The protection layer 806 suppresses permeation of water into the organic compound layer. The protection layer is shown as a single layer but may include a plurality of layers. Each layer can be an inorganic compound layer or an organic compound layer.

The color filter 807 is divided into color filters 807R, 807G, and 807B by colors. The color filters can be formed on a planarizing film (not shown). A resin protection layer (not shown) may be arranged on the color filters. The color filters can be formed on the protection layer 806. Alternatively, the color filters can be provided on the counter substrate such as a glass substrate, and then the substrate may be bonded.

A display device 800 (corresponding to the above-described light emitting device 100) shown in Fig. 13B is provided with an organic light emitting element 826 and a TFT 818 as an example of a transistor. A substrate 811 of glass, silicon, or the like is provided and an insulating layer 812 is provided on the substrate 811. The active element such as the TFT 818 is arranged on the insulating layer, and a gate electrode 813, a gate insulating film 814, and a semiconductor layer 815 of the active element are arranged. The TFT 818 further includes the semiconductor layer 815, a drain electrode 816, and a source electrode 817. An insulating film 819 is provided on the TFT 818. The source electrode 817 and an anode 821 forming the organic light emitting element 826 are connected via a contact hole 820 formed in the insulating film.

A method of electrically connecting the electrodes (anode and cathode) included in the organic light emitting element 826 and the electrodes (source electrode and drain electrode) included in the TFT is not limited to that shown in Fig. 13B. That is, one of the anode and cathode and one of the source electrode and drain electrode of the TFT are electrically connected. The TFT indicates a thin-film transistor.

In the display device 800 shown in Fig. 13B, an organic compound layer is illustrated as one layer. However, an organic compound layer 822 may include a plurality of layers. A first protection layer 824 and a second protection layer 825 are provided on a cathode 823 to suppress deterioration of the organic light emitting element.

A transistor is used as a switching element in the display device 800 shown in Fig. 13B but may be used as another switching element.

The transistor used in the display device 800 shown in Fig. 13B is not limited to a transistor using a single-crystal silicon wafer, and may be a thin-film transistor including an active layer on an insulating surface of a substrate. Examples of the active layer include single-crystal silicon, amorphous silicon, non-single-crystal silicon such as microcrystalline silicon, and a non-single-crystal oxide semiconductor such as indium zinc oxide and indium gallium zinc oxide. Note that a thin-film transistor is also called a TFT element.

The transistor included in the display device 800 shown in Fig. 13B may be formed in the substrate such as a silicon substrate. Forming the transistor in the substrate means forming the transistor by processing the substrate such as a silicon substrate. That is, when the transistor is included in the substrate, it can be considered that the substrate and the transistor are formed integrally.

The light emission luminance of the organic light emitting element according to this embodiment can be controlled by the TFT which is an example of a switching element, and the plurality of organic light emitting elements can be provided in a plane to display an image with the light emission luminances of the respective elements. Here, the switching element according to this embodiment is not limited to the TFT, and may be a transistor formed from low-temperature polysilicon or an active matrix driver formed on the substrate such as a silicon substrate. The term "on the substrate" may mean "in the substrate". Whether to provide a transistor in the substrate or use a TFT is selected based on the size of the display unit. For example, if the size is about 0.5 inch, the organic light emitting element may be provided on the silicon substrate.

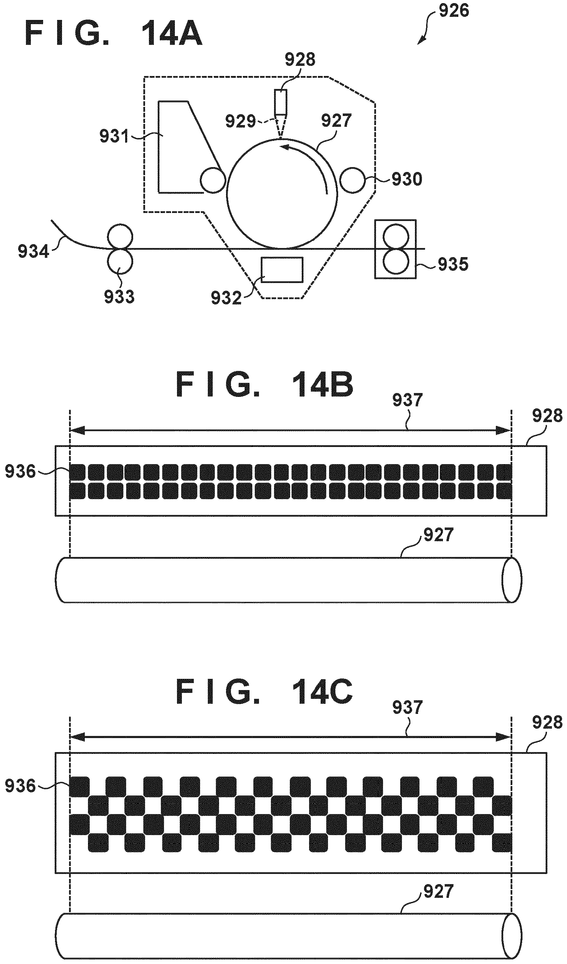

Figs. 14A to 14C are schematic views showing an example of an image forming device using the light emitting device 100 according to this embodiment. An image forming device 926 shown in Fig. 14A includes a photosensitive member 927, an exposure light source 928, a developing unit 931, a charging unit 930, a transfer device 932, a conveyance unit 933 (a conveyance roller in the arrangement shown in Fig. 14A), and a fixing device 935.

Light 929 is emitted from the exposure light source 928, and an electrostatic latent image is formed on the surface of the photosensitive member 927. The light emitting device 100 can be applied to the exposure light source 928. The developing unit 931 can function as a developing device that includes a toner or the like as a developing agent and applies the developing agent to the exposed photosensitive member 927. The charging unit 930 charges the photosensitive member 927. The transfer device 932 transfers the developed image to a print medium 934. The conveyance unit 933 conveys the print medium 934. The print medium 934 can be, for example, paper, a film, or the like. The fixing device 935 fixes the image formed on the print medium.

Each of Figs. 14B and 14C is a schematic view showing a form in which a plurality of light emitting units 936 are arranged in the exposure light source 928 along the longitudinal direction of a long substrate. The light emitting device 100 can be applied to each of the light emitting units 936. That is, the plurality of light emitting elements 103 arranged in the display region 101 are arranged along the longitudinal direction of the substrate. A direction 937 is a direction parallel to the axis of the photosensitive member 927. This column direction matches the direction of the axis upon rotating the photosensitive member 927. This direction 937 can also be referred to as the long-axis direction of the photosensitive member 927.

Fig. 14B shows a form in which the light emitting units 936 are arranged along the long-axis direction of the photosensitive member 927. Fig. 14C shows a form, which is a modification of the arrangement of the light emitting units 936 shown in Fig. 14B, in which the light emitting units 936 are arranged in the column direction alternately between the first column and the second column. The light emitting units 936 are arranged at different positions in the row direction between the first column and the second column. In the first column, the plurality of light emitting units 936 are arranged apart from each other. In the second column, the light emitting unit 936 is arranged at the position corresponding to the space between the light emitting units 936 in the first column. Furthermore, in the row direction, the plurality of light emitting units 936 are arranged apart from each other. The arrangement of the light emitting units 936 shown in Fig. 14C can be referred to as, for example, an arrangement in a grid pattern, an arrangement in a staggered pattern, or an arrangement in a checkered pattern.

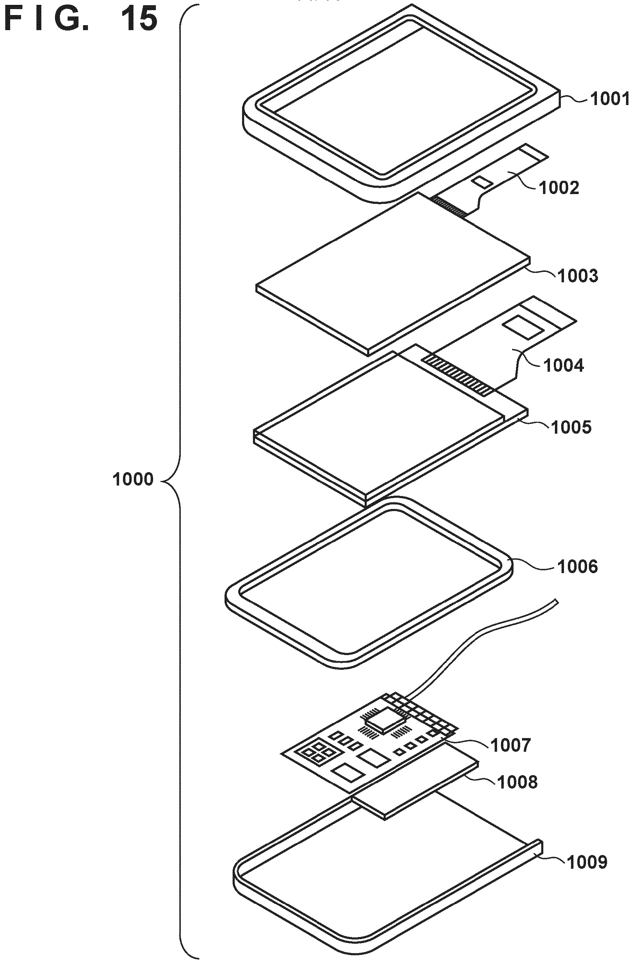

Fig. 15 is a schematic view showing an example of the display device using the light emitting device 100 according to this embodiment. A display device 1000 can include a touch panel 1003, a display panel 1005, a frame 1006, a circuit board 1007, and a battery 1008 between an upper cover 1001 and a lower cover 1009. Flexible printed circuits (FPCs) 1002 and 1004 are respectively connected to the touch panel 1003 and the display panel 1005. Active elements such as transistors are arranged on the circuit board 1007. The battery 1008 is unnecessary if the display device 1000 is not a portable apparatus. Even when the display device 1000 is a portable apparatus, the battery 1008 need not be provided at this position. The light emitting device 100 can be applied to the display panel 1005. The light emitting elements 103 arranged in the display region 101 of the light emitting device 100 functioning as the display panel 1005 operate in a state in which they are connected to the active elements such as transistors arranged on the circuit board 1007.

The display device 1000 shown in Fig. 15 can be used for a display unit of a photoelectric conversion device (also referred to as an image capturing device) including an optical unit having a plurality of lenses, and an image sensor for receiving light having passed through the optical unit and photoelectrically converting the light into an electric signal. The photoelectric conversion device can include a display unit for displaying information acquired by the image sensor. In addition, the display unit can be either a display unit exposed outside the photoelectric conversion device, or a display unit arranged in the finder. The photoelectric conversion device can be a digital camera or a digital video camera.

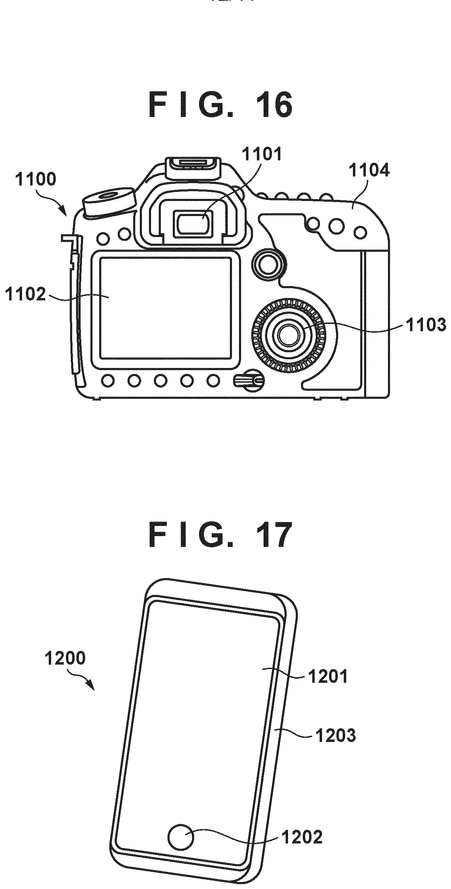

Fig. 16 is a schematic view showing an example of the photoelectric conversion device using the light emitting device 100 according to this embodiment. A photoelectric conversion device 1100 can include a viewfinder 1101, a rear display 1102, an operation unit 1103, and a housing 1104. The photoelectric conversion device 1100 can also be called an image capturing device. The light emitting device 100 according to this embodiment can be applied to the viewfinder 1101 or the rear display 1102 as a display unit. In this case, the display region 101 of the light emitting device 100 can display not only an image to be captured but also environment information, image capturing instructions, and the like. Examples of the environment information are the intensity and direction of external light, the moving velocity of an object, and the possibility that an object is covered with an obstacle.

The timing suitable for image capturing is a very short time in many cases, so the information should be displayed as soon as possible. Therefore, the light emitting device 100 in which the light emitting element 103 using the organic light emitting material such as an organic EL element is arranged in the display region 101 may be used for the viewfinder 1101 or the rear display 1102. This is so because the organic light emitting material has a high response speed. The light emitting device 100 using the organic light emitting material can be used for the devices that require a high display speed more suitably than for the liquid crystal display device.

The photoelectric conversion device 1100 includes an optical unit (not shown). This optical unit has a plurality of lenses, and forms an image on a photoelectric conversion element (not shown) that receives light having passed through the optical unit and is accommodated in the housing 1104. The focal points of the plurality of lenses can be adjusted by adjusting the relative positions. This operation can also automatically be performed.

The light emitting device 100 may be applied to a display unit of an electronic apparatus. At this time, the display unit can have both a display function and an operation function. Examples of the portable terminal are a portable phone such as a smartphone, a tablet, and a head mounted display.

Fig. 17 is a schematic view showing an example of an electronic apparatus using the light emitting device 100 according to this embodiment. An electronic apparatus 1200 includes a display unit 1201, an operation unit 1202, and a housing 1203. The housing 1203 can accommodate a circuit, a printed board having this circuit, a battery, and a communication unit. The operation unit 1202 can be a button or a touch-panel-type reaction unit. The operation unit 1202 can also be a biometric authentication unit that performs unlocking or the like by authenticating the fingerprint. The portable apparatus including the communication unit can also be regarded as a communication apparatus. The light emitting device 100 according to this embodiment can be applied to the display unit 1201.

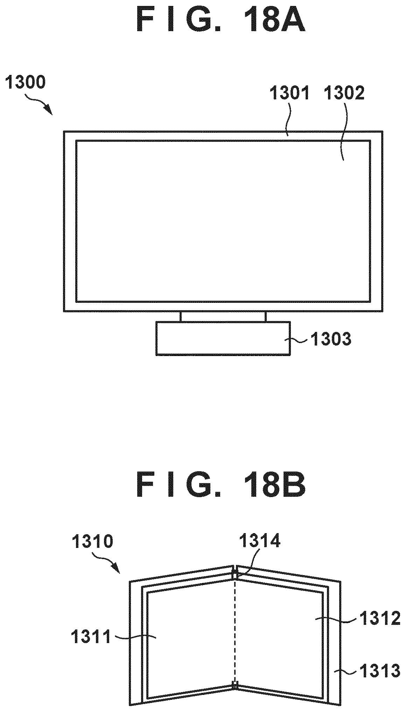

Figs. 18A and 18B are schematic views showing examples of the display device using the light emitting device 100 according to this embodiment. Fig. 18A shows a display device such as a television monitor or a PC monitor. A display device 1300 includes a frame 1301 and a display unit 1302. The light emitting device 100 according to this embodiment can be applied to the display unit 1302. The display device 1300 can include a base 1303 that supports the frame 1301 and the display unit 1302. The base 1303 is not limited to the form shown in Fig. 18A. For example, the lower side of the frame 1301 may also function as the base 1303. In addition, the frame 1301 and the display unit 1302 can be bent. The radius of curvature in this case can be 5,000 mm (inclusive) to 6,000 mm (inclusive).

Fig. 18B is a schematic view showing another example of the display device using the light emitting device 100 according to this embodiment. A display device 1310 shown in Fig. 18B can be folded, and is a so-called foldable display device. The display device 1310 includes a first display unit 1311, a second display unit 1312, a housing 1313, and a bending point 1314. The light emitting device 100 according to this embodiment can be applied to each of the first display unit 1311 and the second display unit 1312. The first display unit 1311 and the second display unit 1312 can also be one seamless display device. The first display unit 1311 and the second display unit 1312 can be divided by the bending point. The first display unit 1311 and the second display unit 1312 can display different images, and can also display one image together.

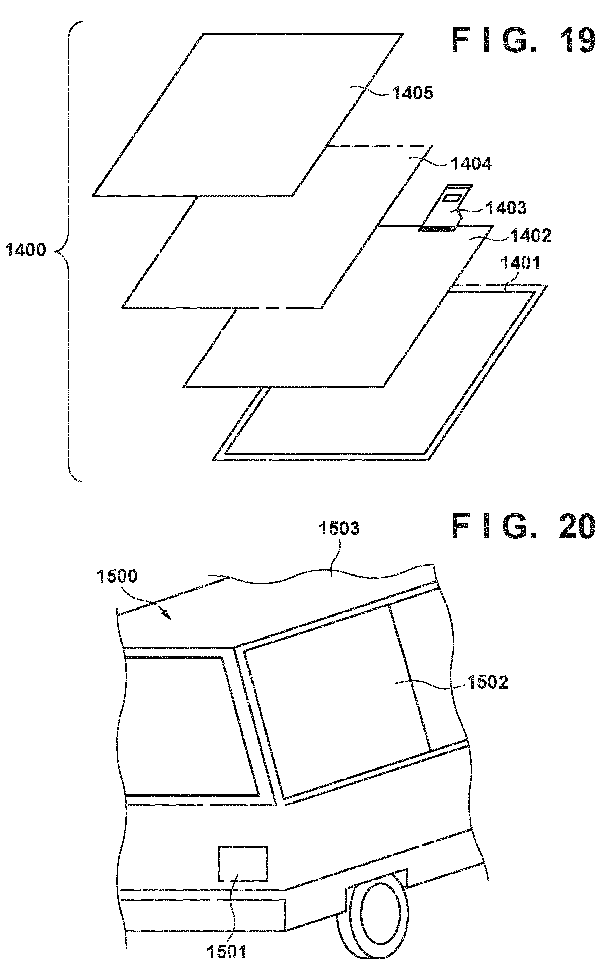

Fig. 19 is a schematic view showing an example of the illumination device using the light emitting device 100 according to this embodiment. An illumination device 1400 can include a housing 1401, a light source 1402, a circuit board 1403, an optical film 1404, and a light diffusing unit 1405. The light emitting device 100 according to this embodiment can be applied to the light source 1402. The optical film 1404 can be a filter that improves the color rendering of the light source. When performing lighting-up or the like, the light diffusing unit 1405 can throw the light of the light source over a broad range by effectively diffusing the light. The illumination device can also include a cover on the outermost portion, as needed. The illumination device 1400 can include both or one of the optical film 1404 and the light diffusing unit 1405.

The illumination device 1400 is, for example, a device for illuminating the interior of the room. The illumination device 1400 can emit white light, natural white light, or light of any color from blue to red. The illumination device 1400 can also include a light control circuit for controlling these light components. The illumination device 1400 can also include a power supply circuit connected to the light emitting device 100 functioning as the light source 1402. The power supply circuit is a circuit for converting an AC voltage into a DC voltage. White has a color temperature of 4,200 K, and natural white has a color temperature of 5,000 K. The illumination device 1400 may also include a color filter. In addition, the illumination device 1400 can include a heat radiation unit. The heat radiation unit radiates the internal heat of the device to the outside of the device, and examples are a metal having a high specific heat and liquid silicon.

Fig. 20 is a schematic view of an automobile having a taillight as an example of a vehicle lighting appliance using the light emitting device 100 according to this embodiment. An automobile 1500 has a taillight 1501, and can have a form in which the taillight 1501 is turned on when performing a braking operation or the like. The light emitting device 100 according to this embodiment can be used as a headlight serving as a vehicle lighting appliance. The automobile is an example of a moving body, and the moving body may be a ship, a drone, an aircraft, a railroad car, an industrial robot, or the like. The moving body may include a main body and a lighting appliance provided in the main body. The lighting appliance may be used to make a notification of the current position of the main body.

The light emitting device 100 according to this embodiment can be applied to the taillight 1501. The taillight 1501 can include a protection member for protecting the light emitting device 100 functioning as the taillight 1501. The material of the protection member is not limited as long as the material is a transparent material with a strength that is high to some extent, and an example is polycarbonate. The protection member may be made of a material obtained by mixing a furandicarboxylic acid derivative, an acrylonitrile derivative, or the like in polycarbonate.

The automobile 1500 can include a vehicle body 1503, and a window 1502 attached to the vehicle body 1503. This window can be a window for checking the front and back of the automobile, and can also be a transparent display such as a head-up display. For this transparent display, the light emitting device 100 according to this embodiment may be used. In this case, the constituent materials of the electrodes and the like of the light emitting device 100 are formed by transparent members.

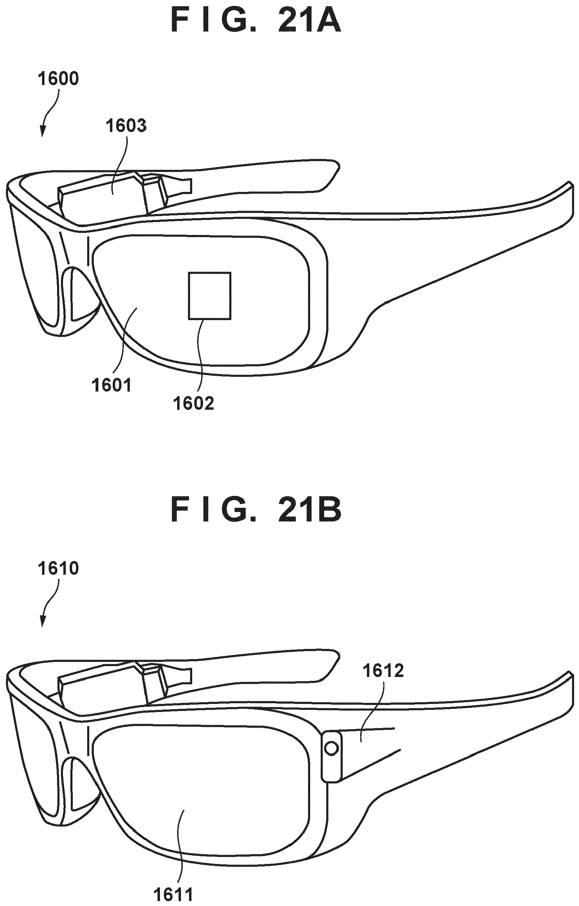

Further application examples of the light emitting device 100 according to this embodiment will be described with reference to Figs. 21A and 21B. The light emitting device 100 can be applied to a system that can be worn as a wearable device such as smartglasses, a Head Mounted Display (HMD), or a smart contact lens. An image capturing display device used for such application examples includes an image capturing device capable of photoelectrically converting visible light and a light emitting device capable of emitting visible light.

Glasses 1600 (smartglasses) according to one application example will be described with reference to Fig. 21A. An image capturing device 1602 such as a CMOS sensor or an SPAD is provided on the surface side of a lens 1601 of the glasses 1600. In addition, the light emitting device 100 according to this embodiment is provided on the back surface side of the lens 1601.

The glasses 1600 further include a control device 1603. The control device 1603 functions as a power supply that supplies electric power to the image capturing device 1602 and the light emitting device 100 according to each embodiment. In addition, the control device 1603 controls the operations of the image capturing device 1602 and the light emitting device 100. An optical system configured to condense light to the image capturing device 1602 is formed on the lens 1601.

Glasses 1610 (smartglasses) according to one application example will be described with reference to Fig. 21B. The glasses 1610 include a control device 1612, and an image capturing device corresponding to the image capturing device 1602 and the light emitting device 100 are mounted on the control device 1612. The image capturing device in the control device 1612 and an optical system configured to project light emitted from the light emitting device 100 are formed in a lens 1611, and an image is projected to the lens 1611. The control device 1612 functions as a power supply that supplies electric power to the image capturing device and the light emitting device 100, and controls the operations of the image capturing device and the light emitting device 100. The control device 1612 may include a line-of-sight detection unit that detects the line of sight of a wearer. The detection of a line of sight may be done using infrared rays. An infrared ray emitting unit emits infrared rays to an eyeball of the user who is gazing at a displayed image. An image capturing unit including a light receiving element detects reflected light of the emitted infrared rays from the eyeball, thereby obtaining a captured image of the eyeball. A reduction unit for reducing light from the infrared ray emitting unit to the display unit in a planar view is provided, thereby reducing deterioration of image quality.

The line of sight of the user to the displayed image is detected from the captured image of the eyeball obtained by capturing the infrared rays. An arbitrary known method can be applied to the line-of-sight detection using the captured image of the eyeball. As an example, a line-of-sight detection method based on a Purkinje image obtained by reflection of irradiation light by a cornea can be used.

More specifically, line-of-sight detection processing based on pupil center corneal reflection is performed. Using pupil center corneal reflection, a line-of-sight vector representing the direction (rotation angle) of the eyeball is calculated based on the image of the pupil and the Purkinje image included in the captured image of the eyeball, thereby detecting the line-of-sight of the user.

The light emitting device 100 according to the embodiment of the present disclosure can include an image capturing device including a light receiving element, and control a displayed image based on the line-of-sight information of the user from the image capturing device.

More specifically, the light emitting device 100 decides a first visual field region at which the user is gazing and a second visual field region other than the first visual field region based on the line-of-sight information. The first visual field region and the second visual field region may be decided by the control device of the light emitting device 100, or those decided by an external control device may be received. In the display region of the light emitting device 100, the display resolution of the first visual field region may be controlled to be higher than the display resolution of the second visual field region. That is, the resolution of the second visual field region may be lower than that of the first visual field region.

In addition, the display region includes a first display region and a second display region different from the first display region, and a region of higher priority is decided from the first display region and the second display region based on line-of-sight information. The first display region and the second display region may be decided by the control device of the light emitting device 100, or those decided by an external control device may be received. The resolution of the region of higher priority may be controlled to be higher than the resolution of the region other than the region of higher priority. That is, the resolution of the region of relatively low priority may be low.

Note that AI may be used to decide the first visual field region or the region of higher priority. The AI may be a model configured to estimate the angle of the line of sight and the distance to a target ahead the line of sight from the image of the eyeball using the image of the eyeball and the direction of actual viewing of the eyeball in the image as supervised data. The AI program may be held by the light emitting device 100, the image capturing device, or an external device. If the external device holds the AI program, it is transmitted to the light emitting device 100 via communication.

When performing display control based on line-of-sight detection, smartglasses further including an image capturing device configured to capture the outside can be applied. The smartglasses can display captured outside information in real time.

While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.

## Claims

1. A light emitting device (100) in which

   a plurality of light emitting elements (103), each of which comprises a light emitting layer and a light extraction structure (104) arranged so as to cover the light emitting layer, are arranged on a main surface (140) of a substrate (110), and
   the plurality of light emitting elements (103) include a red light emitting element (103r) configured to emit red light, a green light emitting element (103g) configured to emit green light, and a blue light emitting element (103b) configured to emit blue light, and comprise a resonant structure corresponding to each light emission color, **characterized in that**
   if $\lambda$on_g [nm] is a resonant peak wavelength in a normal direction of the main surface (140) in the resonant structure of the green light emitting element (103g), $\lambda$g [nm] is a peak wavelength of an emission spectrum of the green light emitting element (103g), $\lambda$on_b [nm] is a resonant peak wavelength in the normal direction of the main surface (140) in the resonant structure of the blue light emitting element (103b), and $\lambda$b [nm] is a peak wavelength of an emission spectrum of the blue light emitting element (103b),

   $$\Delta g = \lambda on\_g - \lambda g > 0 \ [nm]$$

   $$\Delta b = \lambda on\_b - \lambda b > 0 \ [nm]$$

   $$\Delta g - \Delta b \geq 0 \ [nm]$$

   are satisfied.

2. The device according to claim 1, **characterized in that**

   $$15 \ [nm] \geq \Delta g - \Delta b \geq 0 \ [nm]$$

   is further satisfied.

3. The device according to claim 1 or 2, **characterized in that**

   $$17 \ [nm] \geq \Delta b > 0 \ [nm]$$

is further satisfied.

4. The device according to any one of claims 1 to 3, **characterized in that**

$$20 \text{ [nm]} \geq \Delta g \geq 10 \text{ [nm]}$$

is further satisfied.

5. The device according to any one of claims 1 to 4, **characterized in that**
   the light extraction structure includes a microlens.

6. The device according to claim 5, **characterized by** comprising a display region where the plurality of light emitting elements are arranged, wherein

   the plurality of light emitting elements further include a first light emitting element arranged between a center and an outer edge of the display region, and
   in an orthogonal projection to the main surface, a center of the microlens arranged in the first light emitting element is arranged between a center of a light emitting region of the first light emitting element where light is emitted and the center of the display region.

7. The device according to claim 6, **characterized in that**

   the plurality of light emitting elements further include a second light emitting element arranged between the center of the display region and the first light emitting element,
   in the orthogonal projection to the main surface, a center of the microlens arranged in the second light emitting element is arranged between a center of a light emitting region of the second light emitting element where light is emitted and the center of the display region, and
   in the orthogonal projection to the main surface, a shift amount between the center of the light emitting region and the center of the microlens in the first light emitting element is larger than a shift amount between the center of the light emitting region and the center of the microlens in the second light emitting element.

8. The device according to claim 6 or 7, **characterized in that**

   the plurality of light emitting elements further include a third light emitting element arranged at the center of the display region, and
   in the orthogonal projection to the main surface, a center of the microlens arranged in the third light emitting element overlaps a center of a light emitting region of the third light emitting element where light is emitted.

9. The device according to any one of claims 1 to 8, **characterized in that**
   a peak wavelength of an emission spectrum of the red light emitting element is not less than 600 nm and not more than 650 nm, a peak wavelength of an emission spectrum of the green light emitting element is not less than 500 nm and not more than 550 nm, and a peak wavelength of an emission spectrum of the blue light emitting element is not less than 440 nm and not more than 480 nm.

10. The device according to any one of claims 1 to 9, **characterized in that**
    the light emitting layer emits white light.

11. The device according to claim 10, **characterized in that**
    each of the plurality of light emitting elements further comprises a color filter.

12. The device according to claim 11, **characterized in that**

    the color filter of the red light emitting element transmits light of not less than 600 nm and not more than 650 nm,
    the color filter of the green light emitting element transmits light of not less than 500 nm and not more than 550 nm, and
    the color filter of the blue light emitting element transmits light of not less than 440 nm and not more than 480 nm.

**13.** A light emitting device (100) in which

a plurality of light emitting elements (103), each of which comprises a light emitting layer and a light extraction structure (104) arranged so as to cover the light emitting layer, are arranged on a main surface (140) of a substrate (110), and

the plurality of light emitting elements (103) include a red light emitting element (103r) configured to emit red light, a green light emitting element (103g) configured to emit green light, and a blue light emitting element (103b) configured to emit blue light, and comprise a resonant structure corresponding to each light emission color, **characterized in that**

in the light emitting device (100), when emitting white light, a color shift between light emission in a normal direction of the main surface (140) and light emission in a direction of 30° with respect to the normal direction of the main surface (140) in an a*b* space falls within a range of $|a^*| \leq 5.0$ and $b^* \leq 0$.

**14.** The device according to claim 13, **characterized in that**
the light extraction structure includes a microlens.

**15.** The device according to claim 14, **characterized by** comprising a display region where the plurality of light emitting elements are arranged, wherein

the plurality of light emitting elements further include a first light emitting element arranged between a center and an outer edge of the display region, and

in an orthogonal projection to the main surface, a center of the microlens arranged in the first light emitting element is arranged between a center of a light emitting region of the first light emitting element where light is emitted and the center of the display region.

**16.** The device according to claim 15, **characterized in that**

the plurality of light emitting elements further include a second light emitting element arranged between the center of the display region and the first light emitting element,

in the orthogonal projection to the main surface, a center of the microlens arranged in the second light emitting element is arranged between a center of a light emitting region of the second light emitting element where light is emitted and the center of the display region, and

in the orthogonal projection to the main surface, a shift amount between the center of the light emitting region and the center of the microlens in the first light emitting element is larger than a shift amount between the center of the light emitting region and the center of the microlens in the second light emitting element.

**17.** A display device **characterized by** comprising the light emitting device according to any one of claims 1 to 16, and an active element connected to the light emitting device.

**18.** A photoelectric conversion device **characterized by** comprising an optical unit including a plurality of microlenses, an image sensor configured to receive light having passed through the optical unit, and a display unit configured to display an image,

wherein the display unit displays an image captured by the image sensor, and includes the light emitting device according to any one of claims 1 to 16.

**19.** An electronic apparatus **characterized by** comprising a housing provided with a display unit, and a communication unit provided in the housing and configured to perform external communication,

wherein the display unit includes the light emitting device according to any one of claims 1 to 16.

**20.** A wearable device **characterized by** comprising a display device configured to display an image,

wherein the display device includes the light emitting device according to any one of claims 1 to 16.

# F I G. 1A

100

101

103

A    A'

102

# F I G. 1B

104    103

A    A'

102

# F I G. 2A

# F I G. 2B

# FIG. 3A

130a · · · 133 · · · 120g · · · 120r · · · 120b · · · 114 · 113 · 112 · 110 · 111

$n_0$ · $n_1$ · $n_2$ · $n_{eml}$

$n_1 = n_2 = n_{eml}$

# FIG. 3B

130b' · 130b · θ=30° · 120g · 133 · 120b · 120r · 114 · 113 · 112 · 110 · 111

$n_0$ · $n_1$ · $n_2$ · $\theta_{eml}$ · $n_{eml}$

# FIG. 3C

130c · 103 · 119 · 120r · 120g · 120b · 114 · 113 · 112 · 110 · 111

$n_0$ · $n_{ml}$ · $n_1$ · $\theta_{eml}$ · $n_2$ · $n_{eml}$

$n_{ml} = n_1 = n_2 = n_{eml}$

# FIG. 3D

130d · θ=30° · 103 · 119 · 130d' · 120r · 114 · 113 · 112 · 110 · 111 · 120b · 120g

$n_0$ · $n_{ml}$ · $n_1$ · $\theta_{eml}$ · $n_2$ · $n_{eml}$

EP 4 475 652 A1

# FIG. 4

# FIG. 5A

103

101

E'

E

# FIG. 5B

153 152 151 150

103-3 103-2 103-1 103-0

119

E E'

117

140

116 123 122 110

# F I G. 6A

NORMALIZED NUMBER OF LIGHT RAYS

RADIATION ANGLE θ eml [deg] IN ORGANIC LAYER

------- ML2_0 DEGREES

——— ML1_0 DEGREES

# F I G. 6B

NORMALIZED NUMBER OF LIGHT RAYS

RADIATION ANGLE θ eml [deg] IN ORGANIC LAYER

------- ML2_30 DEGREES

——— ML1_30 DEGREES

# FIG. 7

# FIG. 8

| | |
|---|---|
| MICROLENS HEIGHT h/D | 0.31 |
| MICROLENS RADIUS r/D | 0.54 |
| HEIGHT d/D BETWEEN SEMI-TRANSMISSIVE ELECTRODE AND COLOR FILTER | 0.56 |

# FIG. 9

| | ML | BPL | Δ=λon−λ [nm] | | | Δg−Δb [nm] | COLOR SHIFT | |
|---|---|---|---|---|---|---|---|---|
| | | | R | G | B | | a*(θ=-30°) | b*(θ=-30°) |
| COMPARATIVE EXAMPLE 1 | NONE | PL1 | 6 | 17 | 2 | 15.0 | -6.8 | 0.1 |
| COMPARATIVE EXAMPLE 2 | ML1 | PL1 | 6 | 18 | -1 | 19.4 | -13.8 | 1.6 |
| COMPARATIVE EXAMPLE 3 | ML1 | PL1 | 14 | 18 | -1 | 19.4 | -12.2 | 2.3 |
| EXAMPLE 1 | ML1 | PL1 | 14 | 14 | 2 | 11.9 | -2.7 | -5.0 |
| EXAMPLE 2 | ML1 | PL1 | 14 | 14 | 4 | 10.2 | -0.8 | -8.9 |

# F I G. 10

| | ML | BPL | Δ=λon−λ [nm] | | | Δg−Δb [nm] | COLOR SHIFT | |
|---|---|---|---|---|---|---|---|---|
| | | | R | G | B | | a*(θ=-30°) | b*(θ=-30°) |
| COMPARATIVE EXAMPLE 4 | ML1 | PL2 | 11 | 18 | 2 | 16.2 | -14.9 | 3.6 |
| COMPARATIVE EXAMPLE 5 | ML1 | PL2 | 11 | 21 | 2 | 19.1 | -20.0 | 5.6 |
| EXAMPLE 3 | ML1 | PL2 | 3 | 15 | 7 | 7.9 | -1.9 | -9.3 |
| EXAMPLE 4 | ML2 | PL2 | 11 | 15 | 7 | 7.9 | -1.3 | -8.9 |

# F I G. 11

| MICROLENS HEIGHT h/D | 0.23 |
|---|---|
| MICROLENS RADIUS r/D | 0.49 |
| HEIGHT d/D BETWEEN SEMI-TRANSMISSIVE ELECTRODE AND COLOR FILTER | 0.56 |

# F I G. 12

| | ML | BPL | Δ=λon−λ [nm] | | | Δg−Δb [nm] | COLOR SHIFT | |
|---|---|---|---|---|---|---|---|---|
| | | | R | G | B | | a*(θ=-30°) | b*(θ=-30°) |
| COMPARATIVE EXAMPLE 6 | ML2 | PL2 | -38 | 18 | -4 | 21.5 | -9.0 | 3.7 |
| COMPARATIVE EXAMPLE 7 | ML2 | PL2 | -17 | 18 | -4 | 21.5 | -8.4 | 4.4 |
| COMPARATIVE EXAMPLE 8 | ML2 | PL2 | -11 | 18 | -4 | 21.5 | -7.8 | 4.2 |
| EXAMPLE 5 | ML2 | PL2 | -18 | 17 | 12 | 4.4 | -0.6 | -7.3 |
| EXAMPLE 6 | ML2 | PL2 | -17 | 17 | 12 | 4.4 | -1.2 | -7.8 |
| EXAMPLE 7 | ML2 | PL2 | -11 | 17 | 12 | 4.4 | 0.1 | -7.3 |

FIG. 13A

FIG. 13B

FIG. 14A

FIG. 14B

FIG. 14C

# F I G. 15

1001

1002

1000

1003

1004

1005

1006

1007

1008

1009

# F I G. 16

1101

1100

1104

1102

1103

# F I G. 17

1200

1201

1203

1202

# F I G.  18A

# F I G.  18B

F I G. 19

1405

1404

1403

1402

1401

1400

F I G. 20

1503

1500

1502

1501

# FIG. 21A

1600

1603

1601

1602

# FIG. 21B

1610

1612

1611

Europäisches
Patentamt

European
Patent Office

Office européen
des brevets

# EUROPEAN SEARCH REPORT

Application Number

EP 24 17 6956

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2007/069996 A1 (KUBA YUTAKA [JP] ET AL) 29 March 2007 (2007-03-29) | 1,3,9,13 | INV. H10K59/80 |
| Y | * paragraphs [0052], [0090] - [0107], [0109]; figures 10,15 * | 5-8, 10-12, 14-20 | H10K59/38 H10K50/858 H10K50/852 |
| A | | 2,4 | |
| | ----- | | |
| Y | US 2022/158134 A1 (HINATA SHOMA [JP] ET AL) 19 May 2022 (2022-05-19) | 5-8, 10-12, 14-20 | |
| | * paragraphs [0043], [0059], [0060], [0063], [0095], [0103], [0106]; figures 5,6A,6B,7 * | | |
| | ----- | | |

TECHNICAL FIELDS
SEARCHED      (IPC)

H10K

The present search report has been drawn up for all claims

| Place of search | Date of completion of the search | Examiner |
|---|---|---|
| The Hague | 16 October 2024 | Faou, Marylène |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

...........................................................................................

& : member of the same patent family, corresponding
    document

EPO FORM 1503 03.82 (P04C01)

EP 4 475 652 A1

## ANNEX TO THE EUROPEAN SEARCH REPORT
## ON EUROPEAN PATENT APPLICATION NO.

EP 24 17 6956

This annex lists the patent family members relating to the patent documents cited in the above-mentioned European search report.
The members are as contained in the European Patent Office EDP file on
The European Patent Office is in no way liable for these particulars which are merely given for the purpose of information.

16-10-2024

| Patent document cited in search report | | Publication date | Patent family member(s) | | Publication date |
|---|---|---|---|---|---|
| US 2007069996 A1 | | 29-03-2007 | CN | 1941401 A | 04-04-2007 |
| | | | JP | 5073842 B2 | 14-11-2012 |
| | | | JP | 2011134726 A | 07-07-2011 |
| | | | US | 2007069996 A1 | 29-03-2007 |
| US 2022158134 A1 | | 19-05-2022 | JP | 2022080974 A | 31-05-2022 |
| | | | US | 2022158134 A1 | 19-05-2022 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007316611 A